# EUROPEAN PATENT SPECIFICATION

(11) **EP 4 535 044 B1**
(45) Date of publication and mention of the grant of the patent: **03.06.2026**
(21) Application number: 24800042.4
(22) Date of filing: 01.04.2024
(51) Int. Cl.: G01V 3/08, G01B 7/00, G01L 1/14

(54) **SENSOR SHEET**
SENSORFOLIE
FEUILLE DE CAPTEUR

(30) Priority: 01.05.2023 JP 2023075712
(43) Date of publication of application: 09.04.2025
(73) Proprietor: Sumitomo Riko Company Limited, Komaki-shi, Aichi 485-8550 (JP)
(72) Inventor: NAKANO Masayoshi, Komaki-shi, Aichi 485-8550 (JP); TAHARA Shinya, Komaki-shi, Aichi 485-8550 (JP); HEKI Kosuke, Komaki-shi, Aichi 485-8550 (JP); OMORI Sho, Komaki-shi, Aichi 485-8550 (JP); HAYAKAWA Tomonori, Komaki-shi, Aichi 485-8550 (JP); NAKANO Katsuhiko, Komaki-shi, Aichi 485-8550 (JP)
(74) Representative: Becker, Eberhard
(86) International application number: PCT/JP2024/013518
(87) International publication number: WO 2024/228311

(56) References cited:
- WO-A1-2014/123222
- WO-A1-2019/077788
- WO-A1-2022/113395
- JP-A- 2019 122 598
- JP-A- 2019 122 598
- JP-A- 2021 082 573
- JP-B2- 6 222 207
- JP-U- S6 136 604
- US-A1- 2017 027 473

## Description

### Technical Field

The disclosure relates to a sensor sheet.

### Related Art

Patent Document 1 discloses a transducer in which an electrode sheet is disposed on a surface of an insulator sheet. The transducer can serve as a sensor sheet that detects contact or approaching of a conductor having an electric potential by using a capacitance change between electrodes.

### Citation List

### Patent Literature

[Patent Document 1] Japanese Laid-open No. 2019-68414

JP 6222207 B2 relates to a method for manufacturing a touch panel having a curved surface shape which is formed by vacuum molding a sensor molding having a transparent electrode printed thereon and a protective molding covering the surface side thereof into a curved shape using the same die. JP 2019-122598 A relates to an electrical stimulation application and device capable of detecting muscle contraction and measurement system. WO 2022/113395 A1 relates to an electrostatic transducer.

### SUMMARY OF INVENTION

The invention is set out in the appended set of claims. The following disclosure serves a better understanding of the present invention.

### Technical Problem

In such technique, the electrode sheet may be made of a conductive cloth. The conductive cloth is manufactured by forming a plating layer made of metal on a cloth woven by yarns.

In the case where an external force is applied to the sensor sheet formed by the conductive cloth, the plating layer formed on the conductive cloth may be broken. When the plating layer is broken, the electrical conduction path in such portion may be cut off. Therefore, there is a concern that with the electrical conduction path in the electrode sheet being cut off, the electrical resistance value of the sensor sheet may increase.

The disclosure has been made in view of such background and aims to provide a sensor sheet in which the increase in electrical resistance value is suppressed.

### Solution to Problem

An aspect of the disclosure relates to a sensor sheet in accordance with claim 1.

### Effects of Invention

According to an aspect of the disclosure, even if the first plating layer formed on the first conductive cloth forming the first electrode sheet is broken, by forming an electrical conduction path by using the first conductive material of the first auxiliary member, the electrical conduction of the first electrode sheet can be assisted. As a result, the increase in the electrical resistance value of the sensor sheet can be suppressed.

The reference numerals in parentheses as described in the claims indicate the correspondence with the specific means described in the embodiments described as follows, and do not limit the technical scope of the disclosure.

### BRIEF DESCRIPTION OF DRAWINGS

FIG. 1 is a front view showing a steering wheel equipped with a sensor sheet according to Embodiment 1.
FIG. 2 is a cross-sectional view taken along line A-A in FIG. 1.
FIG. 3 is a plan view showing the sensor sheet of Embodiment 1.
FIG. 4 is a cross-sectional view taken along line B-B in FIG. 3.
FIGs. 5A and 5B are partially enlarged plan views showing a first electrode sheet of Embodiment 1, where FIG. 5A shows a state in which the first plating layer is not broken, and FIG. 5B shows a state in which a portion of the first plating layer is broken.
FIG. 6 is a partially enlarged plan view showing a third conductive cloth of a first auxiliary member according to Embodiment 1.
FIG. 7 is a partially enlarged plan view showing another form of the third conductive cloth.
FIG. 8 is a partially enlarged cross-sectional side view showing the sensor sheet of Embodiment 1.
FIG. 9 is a schematic cross-sectional view for describing an electrical conduction path of the sensor sheet of Embodiment 1.
FIG. 10 is a schematic plan view showing a relationship between the orientation direction of a first yarn of the first conductive cloth and the orientation direction of a third yarn of the third conductive cloth according to Embodiment 1.
FIG. 11 is a cross-sectional view showing a sensor sheet according to Embodiment 2.
FIG. 12 is a cross-sectional view showing a sensor sheet according to Embodiment 3.
FIG. 13 is a cross-sectional view showing a sensor sheet according to Embodiment 4.
FIG. 14 is a partially enlarged plan view showing a second conductive cloth according to Embodiment 4.

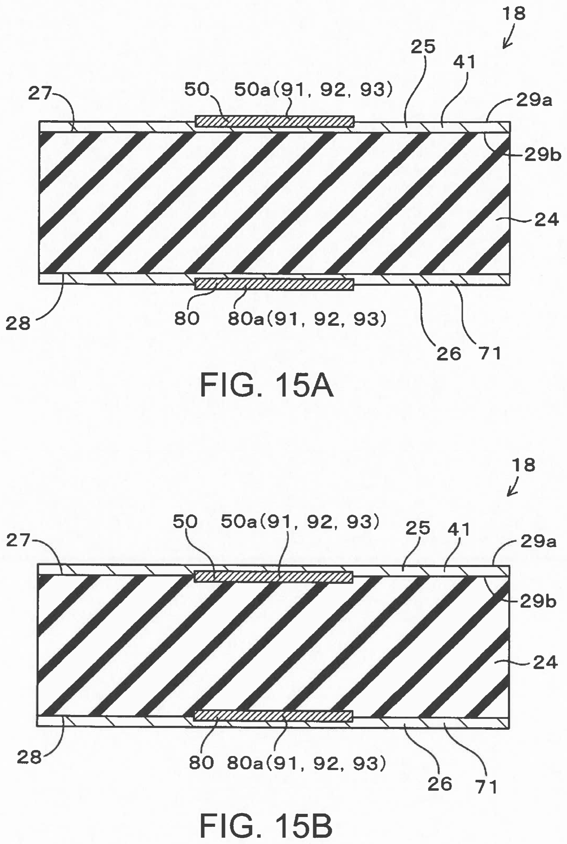

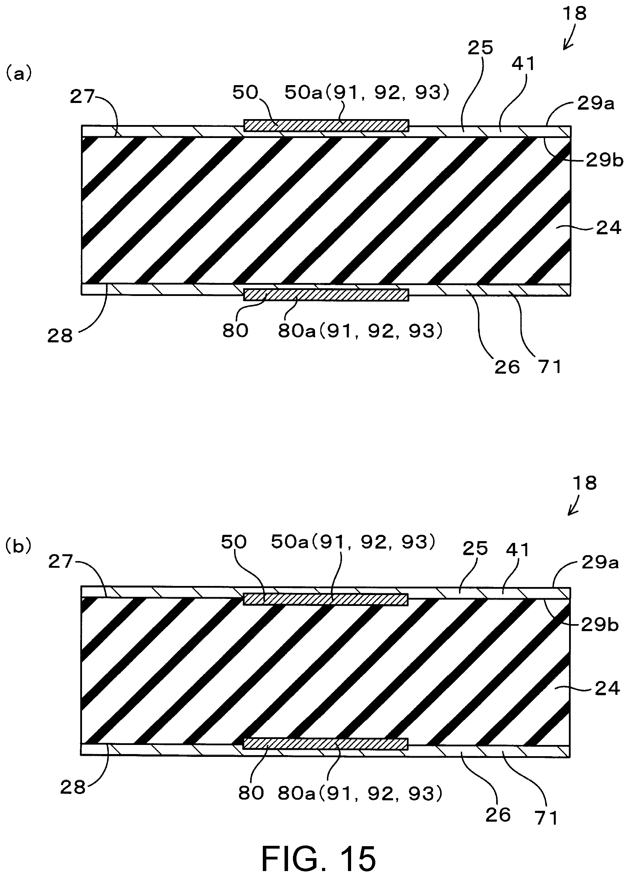

FIGs. 15A and 15B are cross-sectional views showing a sensor sheet according to Embodiment 5, where FIG. 15A is a configuration in which a first auxiliary member is disposed on a first surface side of a first electrode sheet and a third auxiliary member is disposed on a surface on a side opposite to the insulator sheet in the second electrode sheet, and FIG. 15B is a configuration in which the first auxiliary member is disposed on a second surface side of the first electrode sheet, and the third auxiliary member is disposed on a surface on the insulator sheet side in the second electrode sheet.

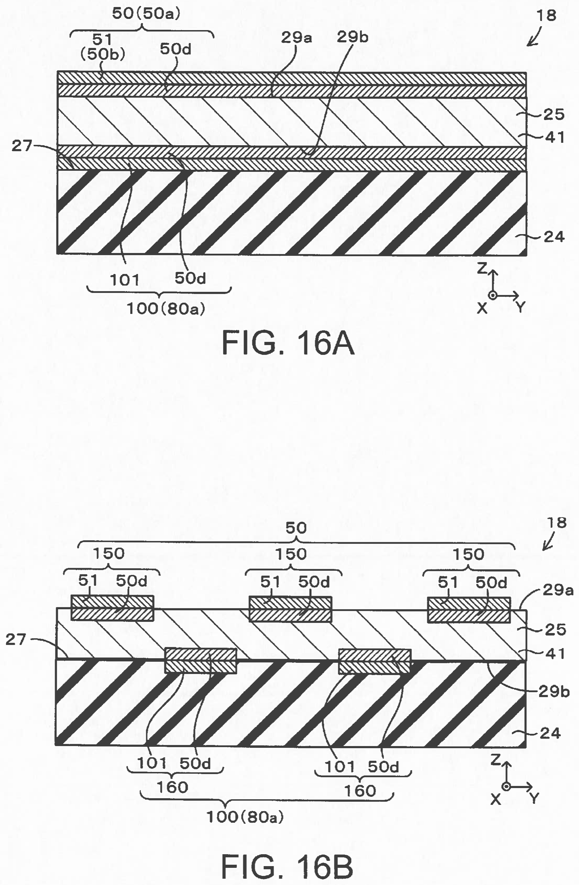

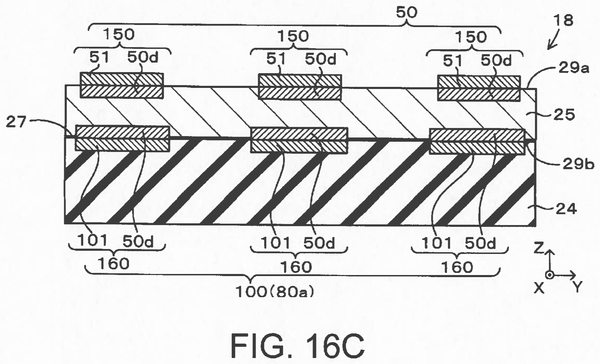

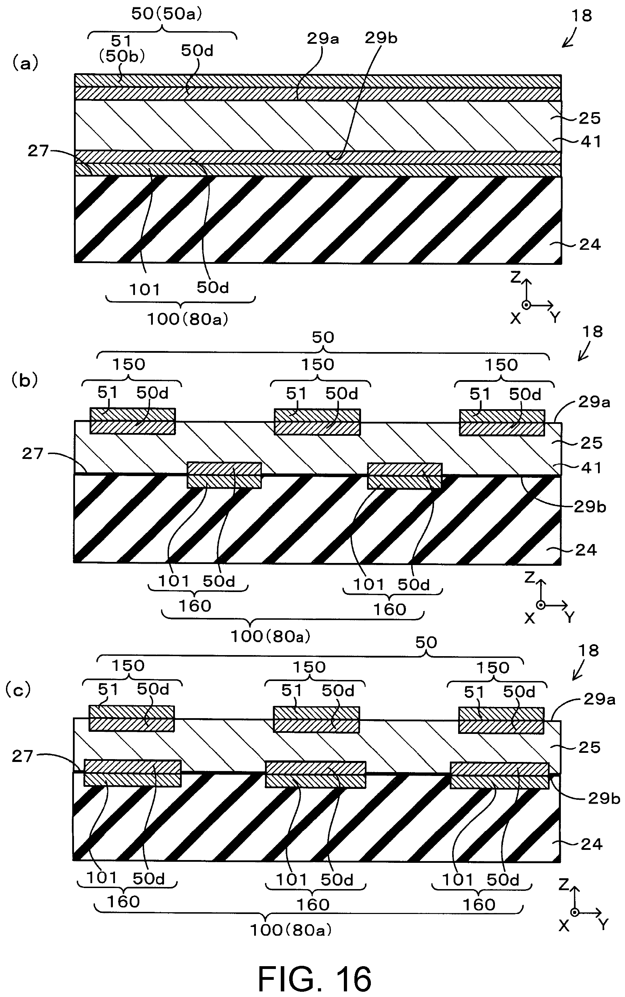

FIGs. 16A to 16C are cross-sectional views showing a sensor sheet according to Embodiment 6, where FIG. 16A is a configuration in which a first auxiliary member is disposed on a first surface of a first electrode sheet, and a second auxiliary member is disposed on a second surface of the first electrode sheet; FIG. 16B is a configuration in which multiple first split auxiliary members and multiple second split auxiliary members do not overlap in a lamination direction; and FIG. 16C is a configuration in which multiple first split auxiliary members and multiple second split auxiliary members overlap in the lamination direction.

### DESCRIPTION OF EMBODIMENTS

### (Embodiment 1)

### 1. Overview of sensor sheet

A sensor sheet is of a capacitive type and serves as a sensor that detects contact or approaching of a conductor having an electric potential by using a capacitance change between electrodes, for example. When a conductor having an electric potential comes into contact with or approaches the sensor sheet, the capacitance between the electrodes changes, and the contact or the approaching of the conductor is detected by detecting a voltage in accordance with the changed capacitance between the electrodes.

The sensor sheet is, for example, attached to a steering wheel of a vehicle to detect whether an occupant's hand (fingers, palm, back of the hand, etc.) has come into contact with or approached the steering wheel.

### 2. Overall configuration of steering wheel 10

First, the structure of a steering wheel 10 is described with reference to FIG. 1 and FIG. 2. As shown in FIG. 1, the steering wheel 10 includes a core part 11, a ring part 12, and multiple (in the embodiment, three) connection parts 13 that connect the core part 11 and the ring part 12. In the following description, for multiple identical components, reference numerals may be assigned to only some of the components, while omitting the reference numerals for other components.

The ring part 12 is formed in a circular ring shape. However, the ring part 12 is not limited to a circular shape and can be formed in any arbitrary shape. The cross-sectional shape perpendicular to the axis of the ring part 12 is formed, for example, in a circular shape as shown in FIG. 2.

### 3. Detailed configuration of steering wheel 10

The detailed configuration of the steering wheel 10 will be described with reference to FIG. 1 and FIG. 2. In particular, the detailed configuration of the ring part 12 will be described.

The ring part 12 includes a core body 16, a resin inner layer material 17, a sensor sheet 18, and a skin material 19. The core body 16 forms the central part of the ring part 12 and is formed in a shape corresponding to the shape of the ring part 12. In other words, the core body 16 is formed in a circular ring shape and has a circular cross-sectional shape perpendicular to the axis. Here, the cross-sectional shape of the core body 16 perpendicular to the axis is not limited to a circular shape and can be any arbitrary shape such as an elliptical shape, an egg shape, a U shape, a C shape, a polygonal shape, etc. In the embodiment, the core body 16 is made of metal such as aluminum or magnesium and possesses conductivity. Materials other than metal can be applied as the material of the core body 16

The resin inner layer material 17 covers the entire circumference of the ring shape of the core body 16 and the entire circumference of the circular cross-section of the core body 16 on the outer surface of the core body 16. In the embodiment, the cross-section of the resin inner layer material 17 perpendicular to the axis is formed in a circular shape. In the case where the core body 16 has a U-shaped cross-section perpendicular to the axis, the resin inner layer material 17 is filled in the U-shaped concave part of the core body 16, in addition to the radially outer side on the cross-section of the core body perpendicular to the axis. The resin inner layer material 17 is formed by injection molding on the outer surface side of the core body 16 and is directly bonded to the outer surface of the core body 16. The cross-sectional shape of the resin inner layer material 17 perpendicular to the axis is not limited to a circular shape and can be any arbitrary shape such as an egg shape, an elliptical shape, a polygonal shape, etc. The resin inner layer material 17 is formed, for example, of a foamed resin. The resin inner layer material 17 uses, for example, a foamed urethane resin. It should be noted that a non-foamed resin can also be used for the resin inner layer material 17.

The sensor sheet 18 is wrapped around the outer surface of the resin inner layer material 17. The sensor sheet 18 forms a C-shape when wrapped around the resin inner layer material 17. The sensor sheet 18 will be described in detail later.

The skin material 19 covers the entire circumference of the ring shape of the sensor sheet 18 on the outer surface (the surface on the side opposite to the resin inner layer material 17 in the sensor sheet 18) of the sensor sheet 18. In other words, in the case where the electrode part of the sensor sheet 18 is exposed on the side of a surface 27 of the insulator sheet 24, the skin material 19 also serves as a covering material of the sensor sheet 18. The skin material 19 is formed by injection molding and is wrapped around the outer surface side of the sensor sheet 18 and bonded to the outer surface of the sensor sheet 18. The skin material 19 is formed, for example, of a urethane resin. The outer surface of the skin material 19 forms a design surface. A non-foamed urethane resin or slightly foamed urethane resin may be used for the skin material 19.

### 4. Overall configuration of sensor sheet 18

The overall configuration of the sensor sheet 18 of Embodiment 1 will be described with reference to FIGs. 3 to 4. As shown in FIG. 3, the sensor sheet 18 is formed in an elongated shape along a longitudinal direction X as a whole. The sensor sheet 18 includes a sheet body part 20 formed in a rectangular shape as a whole. The sheet body part 20 includes a pair of long side edges 20a extending along the longitudinal direction X, and a pair of short side edges 20b extending in a direction crossing the longitudinal direction X. In the following description, an arrow sign X indicates the longitudinal direction X of the sensor sheet 18, an arrow sign Y indicates a cross direction crossing the longitudinal direction X, and an arrow sign Z indicates the thickness direction (lamination direction) of the sensor sheet 18. In the following drawings, although not specifically mentioned, for the ease of description, the thickness dimension may be emphasized in some cases.

Sheet concave parts 21 are formed on the pair of long side edges 20a of the sheet body part 20. The sheet concave parts 21 are recessed inward in the cross direction Y crossing the longitudinal direction X. The sheet concave parts 21 are formed at positions including regions that overlap in the cross direction Y in the pair of long side edges 20a of the sheet body part 20. However, it may also be configured that the sheet concave parts 21 are formed only on one of the pair of long side edges 20a.

Multiple (four in the embodiment) sheet concave parts 21 are formed at intervals on one long side edge 20a. However, it may also be that a single sheet concave part 21 is formed on one long side edge 20a. Additionally, two to three or five or more sheet concave parts 21 may be formed on one long side edge 20a.

On one of the pair of long side edges 20a of the sheet body part 20, sheet extension parts 22 are formed at positions near both ends in the longitudinal direction X. The sheet extension parts 22 extend from one long side edge 20a in a direction crossing the longitudinal direction X. The sheet extension parts 22 can be formed at arbitrary positions on the sheet body part 20.

The sheet extension part 22 is formed in a shape that extends along the cross direction Y and then bends in the longitudinal direction X. The sheet extension part 22 includes a linking part 22a that links the sheet extension part 22 and the sheet body part 20, and a wire connection part 22b which extends in the longitudinal direction X from the end of the linking part 22a and to which an electric wire 32 is connected. The sheet extension part 22 (linking parts 22a, wire connection part 22b) can be formed in any shape, such as making the linking part 22a of the sheet extension part 22 serve also as the wire connection part 22b.

FIG. 4 is a cross-sectional view of the sensor sheet 18. The sensor sheet 18 includes an insulator sheet 24, a first electrode sheet 25, a second electrode sheet 26, a first auxiliary member 50, and a third auxiliary member 80. The first electrode sheet 25 and the second electrode sheet 26 are conductive and formed in a layered structure.

The first electrode sheet 25 is laminated on the surface 27 of the insulator sheet 24. The first electrode sheet 25 is formed in a similar shape slightly smaller than the insulator sheet 24. As a result, the end edge part of the surface 27 of the insulator sheet 24 is exposed from the end edge part of the first electrode sheet 25.

As shown in FIG. 3, the first electrode sheet 25 includes a body part 25a that is elongated in the longitudinal direction X. In the body part 25a, at positions corresponding to the sheet concave parts 21 of the sensor sheet 18, concave parts 30 are formed to be recessed inward in the cross direction Y. The portion of the body part 25a sandwiched between two concave parts 30 arranged in the cross direction Y is designated as a first neck part 25b (an example of a neck part). The first neck part 25b is narrower in the cross direction Y than other portions. A portion of the body part 25a adjacent to the first neck part 25b in the longitudinal direction X is designated as a wide part 25c. The wide part 25c is wider than the first neck part 25b in the cross direction Y.

In the first electrode sheet 25, at positions corresponding to the sheet extension parts 22 of the sensor sheet 18, extension parts 25d are formed extending along the cross direction Y crossing the longitudinal direction X from the long side edge of the body part 25a of the first electrode sheet 25 along the longitudinal direction X. The extension part 25d includes a second neck part 25e (an example of a neck part) that overlaps with the linking part 22a of the sheet body part 20, and a terminal part 25f which extends along the cross direction Y from the end of the second neck part 25e and to which a core wire 32a exposed from the end of the electric wire 32 is connected. The second neck part 25e is formed between the body part 25a and the terminal part 25f. The terminal part 25f is connected to an external circuit via the electric wire 32.

In the longitudinal direction X, the width dimension of the second neck part 25e is formed smaller than the length dimension of the terminal part 25f in the longitudinal direction X and the width dimension of the terminal part 25f in the cross direction Y. The wide part 25c of the first electrode sheet 25 that is continuous with the second neck part 25e is formed wider than the second neck part 25e in the longitudinal direction X. The terminal part 25f of the first electrode sheet 25 that is continuous with the second neck part 25e is formed wider in the longitudinal direction X than the second neck part 25e, and is considered an example of the wide part 25c.

The core wire 32a exposed from the end of the electric wire 32 is connected to the terminal part 25f. The core wire 32a and the terminal part 25f are electrically connected through a conventional technique, such as soldering, brazing, ultrasonic welding, etc.

As shown in FIG. 4, the second electrode sheet 26 is laminated on an other surface 28 of the insulator sheet 24. The second electrode sheet 26 is formed in a similar shape slightly smaller than the insulator sheet 24. As a result, the end edge part of the other surface 28 of the insulator sheet 24 is exposed from the end edge part of the second electrode sheet 26.

The first electrode sheet 25 and the second electrode sheet 26 may be of the same shape and size, or one may be a slightly larger in a similar shape than the other.

It should be noted that since the second electrode sheet 26 has substantially the same structure as the first electrode sheet 25, some repeated descriptions may be omitted in the following description.

The insulator sheet 24 is formed, for example, by containing an elastomer as the main component. Therefore, the insulator sheet 24 is flexible. That is, the insulator sheet 24 is configured to be flexible and extensible in the surface direction. The insulator sheet 24 is formed, for example, by containing a thermoplastic material, particularly a thermoplastic elastomer, as the main component. The insulator sheet 24 may be formed by the thermoplastic elastomer itself, or the insulator sheet 24 may be formed with a main component of an elastomer cross-linked by heating the thermoplastic elastomer as a raw material.

Additionally, the insulator sheet 24 may include rubber, resin, foamed resin, or other materials other than thermoplastic elastomer. For example, in the case where the insulator sheet 24 includes rubber such as ethylene-propylene rubber (EPM, EPDM), the flexibility of the insulator sheet 24 is improved. From the viewpoint of improving the flexibility of the insulator sheet 24, the insulator sheet 24 may contain a flexibility-imparting component, such as a plasticizer. Furthermore, the insulator sheet 24 may be configured with a reaction-curable elastomer or a thermosetting elastomer as the main component.

Furthermore, a material with favorable thermal conductivity is suitable for the insulator sheet 24. Therefore, the insulator sheet 24 may use a thermoplastic elastomer with high thermal conductivity, or the insulator sheet 24 may contain a filler that can increase thermal conductivity. Additionally, the insulator sheet 24 may have a configuration with a foamed structure having a fine air layer. Moreover, the insulator sheet 24 may have a structure with perforations (regular physical holes represented by perforated lines) or slits (cuts, notches).

The first electrode sheet 25 is disposed on the side of the surface 27 of the insulator sheet 24, that is, the upper surface side (the upper surface in FIG. 4) of the insulator sheet 24, and the second electrode sheet 26 is disposed on the side of the other surface 28 of the insulator sheet 24, that is, the lower surface (the lower surface in FIG. 4) of the insulator sheet 24. At least the first electrode sheet 25 forms a detection electrode. The first electrode sheet 25 and the second electrode sheet 26 are conductive. Furthermore, the first electrode sheet 25 and the second electrode sheet 26 are flexible. In other words, the first electrode sheet 25 and the second electrode sheet 26 are configured to be flexible and extensible in the surface direction.

As shown in FIG. 4, the first auxiliary member 50 is disposed on the first surface 29a of the first electrode sheet 25 positioned on the side opposite to the insulator sheet 24. Additionally, as shown in FIG. 3, the first auxiliary member 50 is disposed to overlap with the first neck part 25b and the second neck part 25e of the first electrode sheet 25.

As shown in FIG. 3, the first auxiliary member 50 fixed to the first neck part 25b is disposed in a region including at least a portion of the first neck part 25b of the body part 25a of the first electrode sheet 25. The first auxiliary member 50 fixed to the first neck part 25b is disposed to straddle the first neck part 25b and the wide part 25c in the longitudinal direction X. However, the first auxiliary member 50 may be configured to be disposed only in the region overlapping with the first neck part 25b.

The first auxiliary member 50 fixed to the second neck part 25e is disposed in a region including at least a portion of the second neck part 25e in the body part 25a of the first electrode sheet 25. The first auxiliary member 50 fixed to the second neck part 25e is disposed to straddle the second neck part 25e and the wide part 25c in the cross direction Y, and is also disposed straddle the second neck part 25e and the terminal part 25f. However, the first auxiliary member 50 may be configured to be disposed only in a region overlapping with the second neck part 25e.

### 5. Configuration of first electrode sheet 25

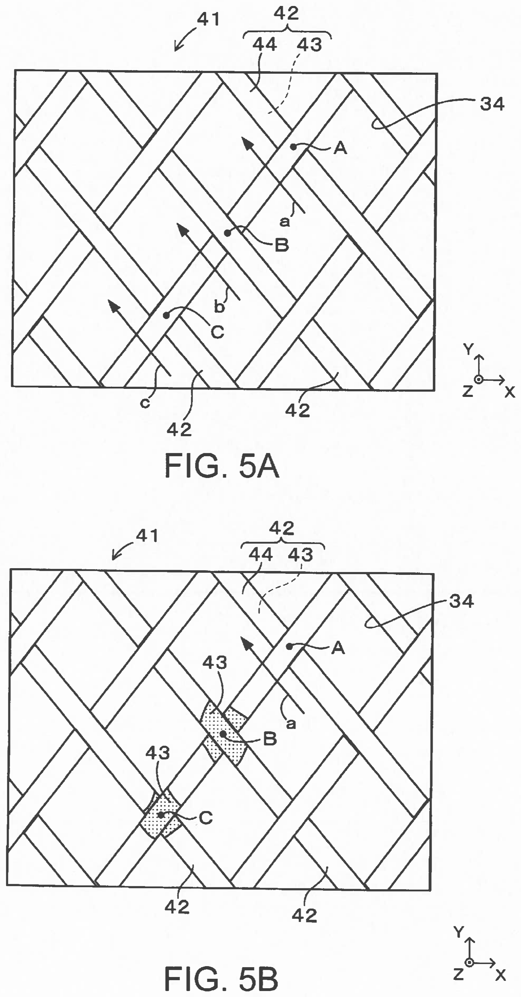

Referring to FIG. 4 to FIGs. 5A and 5B, the configuration of the first electrode sheet 25 will be described. As shown in FIG. 5A, the first electrode sheet 25 is formed by a first conductive cloth 41 exhibiting conductivity. The first electrode sheet 25 possesses conductivity as well as flexibility. The first electrode sheet 25 has stretchability in both the longitudinal direction X and the cross direction Y. The first electrode sheet 25 includes multiple first yarns 42 that are conductive.

The first conductive cloth 41 includes a first plating layer 44. The first plating layer 44 is made of a conductive metal on the surface of a fabric woven by multiple first fibers 43 made of resin. The first yarns 42 are configured by forming the first plating layer 44 on the surfaces of the first fibers 43. However, it is not necessary for the all the surfaces of the first yarns 42 to be covered by the first plating layer 44.

The manufacturing method of the first electrode sheet 25 is not particularly limited. For example, the first electrode sheet 25 may be manufactured by covering with a conductive material a cloth formed by weaving resin-made first fibers 43, or by weaving the first yarns 42 covered with a conductive material on the surfaces of the first fibers 43. In the embodiment, the first electrode sheet 25 is manufactured by forming the first plating layer 44 made of a conductive material on a cloth formed by weaving the first fibers 43 made of resin.

As a resin forming the first yarn 42, examples may include polyolefin such as polyethylene and polypropylene, polyester such as polyethylene terephthalate and polybutylene terephthalate, and polyamide such as nylon 6 and nylon 6,6. However, the resin forming the first yarn 42 is not limited to the above, and any resin can be appropriately selected.

As the metal plated on the first yarn 42, any metal or alloy can be appropriately selected, such as copper, nickel, tin, solder, etc. The first plating layer 44 formed on the surface of the first fiber 43 may be formed by a single metal type or multiple metal types. For example, it may be that only copper is plated on the surface of the first fiber 43, only nickel is plated on the surface of the first fiber 43, or it may be that a copper plating layer made of copper is formed on the surface of the first fiber 43, and a nickel plating layer made of nickel is formed on the surface of the copper plating layer. The first plating layer 44 formed on the surface of the first fiber 43 may be formed by electrolytic plating or by electroless plating.

As shown in FIG. 5A, the first electrode sheet 25 of the embodiment is formed by weaving multiple first yarns 42. The first electrode sheet 25 includes an opening part 34 as a gap between multiple first yarns 42.

As shown in FIG. 5A, each first yarn 42 is formed by a single first fiber 43. However, each first yarn 42 may be formed by a non-twisted yarn bundle wire in which multiple first fibers 43 are bundled without being twisted, or may be formed by a twisted wire in which multiple first fibers 43 are twisted together.

As shown in FIG. 5A, the orientation direction of the first yarn 42 intersects with the longitudinal direction X of the first electrode sheet. The orientation direction of the first yarn 42 is set at an acute angle that is substantially 45° with respect to the longitudinal direction X of the first electrode sheet 25. The expression "substantially 45°" means that, for example, the acute angle is set between 35° and 55° with respect to the longitudinal direction X of the first electrode sheet 25.

However, the orientation direction of the first yarn 42 may be at an acute angle substantially different from 45° with respect to the longitudinal direction X of the first electrode sheet 25.

As shown in FIG. 5A, the intervals between adjacent first yarns 42 are arranged as substantially equal intervals. However, the expression "substantially equal intervals" includes the case where the intervals are equal, as well as the case where the intervals are not equal but can be recognized as substantially equal. However, the intervals between adjacent first yarns 42 may also be different.

As shown in FIG. 4, at least a portion of the first electrode sheet 25 is embedded on the side of the surface 27 of the insulator sheet 24. It may be that only a portion of the first electrode sheet 25 is embedded in the insulator sheet 24, or the entire first electrode sheet 25 is embedded in the insulator sheet 24. Additionally, the first electrode sheet 25 may be bonded to the insulator sheet 24 by using a conventional bonding technique, such as a bonding agent or an adhesive, without being embedded in the insulator sheet 24.

A portion of the insulator sheet 24 is present inside the opening part 34 of the first electrode sheet 25 as a fusion bonding material that fuses and bonds the first electrode sheet 25 and the insulator sheet 24. The opening part 34 of the first electrode sheet 25 is in a state of being filled with a portion of the insulator sheet 24.

### 6. First auxiliary member 50

The first auxiliary member 50 is described with reference to FIG. 4 and FIG. 6 to FIG. 8. As shown in FIG. 4, the first auxiliary member 50 according to the embodiment includes a first conductive material 50a that is conductive. The first auxiliary member 50 is disposed on the surface 27 of the first electrode sheet 25. The first auxiliary member 50 is disposed in a state where the first conductive cloth 41 and the first conductive material 50a are electrically connected. The first auxiliary member 50 forms an electrical conduction path at the portion where the first plating layer 44 of the first conductive cloth 41 is broken. The first conductive material 50a may be configured to include the same metal as the metal forming the first plating layer 44 formed on the first conductive cloth 41.

The first conductive material 50a of the first auxiliary member 50 is a laminate of a conductor layer 50b including a conductor and a conductive bonding layer or a conductive adhesive layer 50d (an example of a conductive adhesive). The conductive bonding layer includes a conductive filler and a curable resin. The conductive adhesive layer 50d includes a conductive filler and a binder resin (an example of an adhesive). The conductor layer 50b and the conductive bonding layer are electrically connected, and the conductor layer 50b and the conductive adhesive layer 50d are electrically connected. In the embodiment, the conductive adhesive layer 50d is adopted.

As the conductive filler, any metal that is conductive can be selected, such as silver or silver alloy, copper or copper alloy, gold or gold alloy. The conductive filler may also include conductive carbon or graphite. For graphite, any graphite can be selected, such as natural graphite, acetylene black, ketjen black, etc. The conductive filler can be in any shape, such as being spherical, flake-like, or foil-like.

As the curable resin, any curable resin can be adopted, such as moisture-curable resin, oxygen-curable resin, two-component curable resin, etc. As the binder resin, any resin can be appropriately selected, such as acrylic adhesive, silicone adhesive, urethane adhesive, rubber-based adhesive, etc.

In the embodiment, the conductor layer 50b is formed by a third conductive cloth 51. As shown in FIG. 6, the third conductive cloth 51 has a third plating layer 54 made of metal on the surface. The third conductive cloth 51 has flexibility as well as conductivity. The third conductive cloth 51 has stretchability in the longitudinal direction X and the cross direction Y. The third conductive cloth 51 includes multiple third yarns 52 that are conductive.

The third conductive cloth 51 includes a third plating layer 54. The third plating layer 54 is made of a conductive metal on the surface of a fabric woven by multiple third fibers 53 made of resin. The third yarns 52 are configured by forming the third plating layer 54 on the surfaces of the third fibers 53. However, it is not necessary for the all the surfaces of the third yarns 52 to be covered by the third plating layer 54. The third plating layer 54 and the conductive bonding layer are electrically connected, and the third plating layer 54 and the conductive adhesive layer 50d are electrically connected.

The manufacturing method of the third conductive cloth 51 is not particularly limited. For example, the third conductive cloth 51 may be manufactured by covering with a conductive material a cloth formed by weaving resin-made third fibers 53, or by weaving the third yarns 52 covered with a conductive material on the surfaces of the third fibers 53. In the embodiment, the third conductive cloth 51 is manufactured by forming the third plating layer 54 made of a conductive material on a cloth formed by weaving the third fibers 53 made of resin.

As a resin forming the third yarn 52, examples may include polyolefin such as polyethylene and polypropylene, polyester such as polyethylene terephthalate and polybutylene terephthalate, and polyamide such as nylon 6 and nylon 6,6. However, the resin forming the first yarn 42 is not limited to the above, and any resin can be appropriately selected.

As the metal plated on the third yarn 52, any metal or alloy can be appropriately selected, such as copper, nickel, tin, solder, etc. The third plating layer 54 formed on the surface of the first fiber 43 may be formed by a single metal type or multiple metal types. For example, it may be that only copper is plated on the surface of the third fiber 53, only nickel is plated on the surface of the third fiber 53, or it may be that a copper plating layer formed of copper is formed on the surface of the third fiber 53, and a nickel plating layer formed of nickel is formed on the surface of the copper plating layer. The third plating layer 54 formed on the surface of the third fiber 53 may be formed by electrolytic plating or by electroless plating.

As shown in FIG. 6, the third conductive cloth 51 of the embodiment includes multiple third yarns 52. In the embodiment, each third yarn 52 is formed of a non-twisted yarn bundle wire in which multiple third fibers 53 are bundled without being twisted. However, similar to the first yarns 42 described above, the third yarn 52 may be formed by a single third fiber 53, or as shown in FIG. 7, may be formed by a twisted wire in which multiple third fibers 53 are twisted together.

As shown in FIG. 6, the orientation direction of the third yarn 52 intersects with the longitudinal direction X of the first electrode sheet 25. The orientation direction of the third yarn 52 is set at an acute angle that is substantially 45° with respect to the longitudinal direction X of the first electrode sheet 25. The expression "substantially 45°" means that, for example, the acute angle is set between 35° and 55° with respect to the longitudinal direction X of the first electrode sheet 25.

However, the orientation direction of the third yarn 52 may be at an acute angle substantially different from 45° with respect to the longitudinal direction X of the first electrode sheet 25.

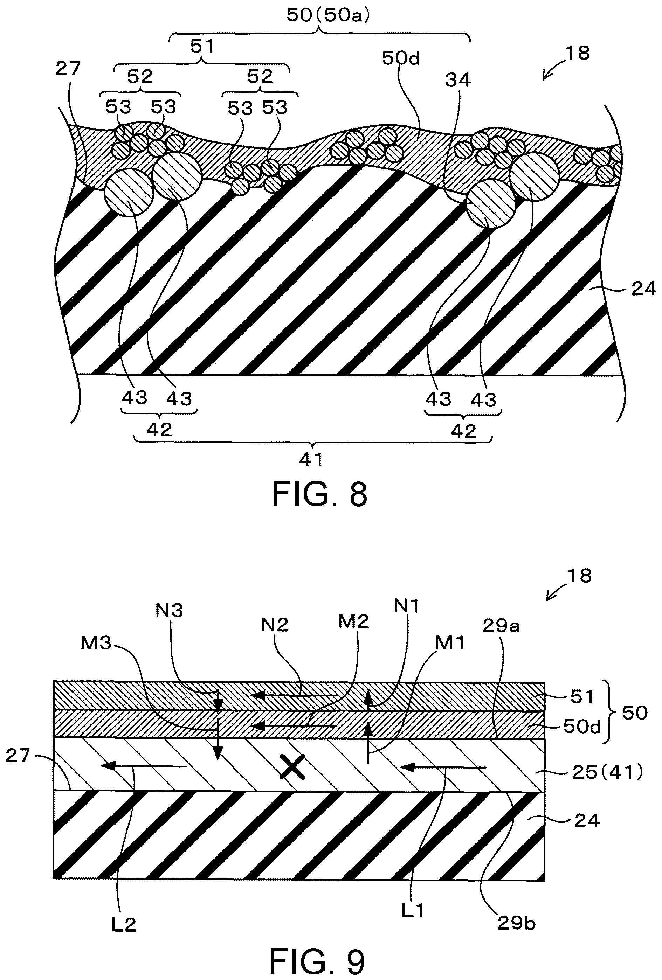

As shown in FIG. 8, at least a portion of the third conductive cloth 51 is embedded in the conductive adhesive layer 50d. It may be that only a portion of the third conductive cloth 51 may be embedded in the conductive adhesive layer 50d, or the entire third conductive cloth 51 is embedded in the conductive adhesive layer 50d. Additionally, the third conductive cloth 51 may be bonded and laminated to the conductive adhesive layer 50d without being embedded in the conductive adhesive layer 50d.

As shown in FIG. 8, in the state where the first auxiliary member 50 is fixed to the first electrode sheet 25, a portion of the first conductive cloth 41 is embedded in the surface 27 of the insulator sheet 24. Additionally, the conductive adhesive layer 50d of the first auxiliary member 50 is filled and placed in the opening part 34 of the first conductive cloth 41. Furthermore, a portion of the third fibers 53 forming the third conductive cloth 51 of the first auxiliary member 50 is disposed in a state of intruding into the opening part 34 of the first conductive cloth 41.

As shown in FIG. 8, the diameter of the third fiber 53 forming the third conductive cloth 51 is formed smaller than the diameter of the first fiber 43 forming the first conductive cloth 41. However, the diameter of the third fiber 53 forming the third conductive cloth 51 may be formed larger than the diameter of the first fiber 43 forming the first conductive cloth 41, or the diameter of the first fiber 43 and the diameter of the third fiber 53 may be formed the same.

As shown in FIG. 8, the first fibers 43 of the first conductive cloth 41 are in contact with the conductive adhesive layer 50d of the first auxiliary member 50. As a result, the first plating layer 44 of the first conductive cloth 41 and the conductive adhesive layer 50d of the first auxiliary member 50 are electrically connected.

Additionally, the first fibers 43 of the first conductive cloth 41 are in contact with the third fibers 53 of the third conductive cloth 51. As a result, the first plating layer 44 of the first conductive cloth 41 and the third plating layer 54 of the third conductive cloth 51 are electrically connected.

As shown in FIG. 4, in the embodiment, the thickness dimension of the first auxiliary member 50 is smaller than the thickness dimension of the first electrode sheet 25.

In the embodiment, the elastic modulus of the first auxiliary member 50 in the longitudinal direction X is greater than the elastic modulus of the first electrode sheet 25 in the longitudinal direction X.

In the embodiment, the bending strength of the first auxiliary member 50 when the first auxiliary member 50 is bent by using a fold line in a direction crossing the longitudinal direction X in the plane of the first auxiliary member 50 is greater than the bending strength of the first electrode sheet 25 when the first electrode sheet 25 is bent by using a fold line in a direction crossing the longitudinal direction X of the first electrode sheet 25.

In the embodiment, the first electrode sheet is formed in an elongated shape in the longitudinal direction X, and the electrical resistivity of the first auxiliary member 50 in the longitudinal direction X is set to be either the same as or smaller than the electrical resistivity of the first electrode sheet in the longitudinal direction X.

### 7. Conduction path of first electrode sheet 25 and first auxiliary member 50

Referring to FIGs. 5A and 5B and FIGs. 9 to 10, the conduction path of the first electrode sheet 25 and the first auxiliary member 50 are described. As shown in FIG. 5A, the first conductive cloth 41 has intersection points A, B, and C where multiple first yarns 42 cross each other. FIG. 5A illustrates the three intersection points A, B, and C as examples. As conduction paths passing through the three intersection points A, B, and C, conduction paths a, b, and c indicated by arrow signs a, b, and c are exemplified.

Here, when an external force is applied to the first conductive cloth 41, stress may concentrate at the intersection points A, B, and C where multiple first yarns 42 cross each other. As a result, the first plating layer 44 tends to be easily broken at the intersection points A, B, and C. However, similar to the above, at the intersection points without reference numerals, the first plating layer 44 also tends to be broken easily.

For example, as shown in FIG. 5B, it is assumed that the first plating layer 44 at the intersection points B and C is broken and the first fibers 43 are exposed. In this case, the conduction paths b and c indicated by the arrow signs b and c in FIG. 5A are cut off. As a result, the conduction path a indicated by the arrow sign a in FIG. 5B remains. This means that the three conduction paths a, b, and c are cut down to one conduction path a. That is, the conductive area is decreased by the amount of the conduction paths b and c. Thus, there is a concern about a decrease in the electrical resistance value of the first conductive cloth 41.

As shown in FIG. 9, in the embodiment, the third conductive cloth 51 and the conductive adhesive layer 50d are laminated on the first conductive cloth 41 that forms the first electrode sheet 25. As a result, even if the conduction path in the portion indicated by "×" in FIG. 9 is cut off in a portion of the first conductive cloth 41, a structure where a conduction path is established by the conductive adhesive layer 50d or the third conductive cloth 51 is formed. This will be described in detail below.

As shown in FIG. 9, in the first conductive cloth 41, the conduction path is cut off between a conduction path L1 indicated by an arrow sign L1 and a conduction path L2 indicated by an arrow sign L2. Therefore, in the case where the first auxiliary member 50 is not disposed, there is a risk that the electrical resistance value of the first electrode sheet 25 may increase.

In the embodiment, since the first conductive cloth 41 and the conductive adhesive layer 50d of the first auxiliary member 50 are electrically connected, conduction paths M1 and M3 are formed between the first conductive cloth 41 and the conductive adhesive layer 50d, as indicated by arrow signs M1 and M3. Additionally, a conduction path M2 is formed within the conductive adhesive layer 50d, as indicated by an arrow sign M2. As a result, in the embodiment, a current flows through the conduction paths L1, M1, M2, M3, and L2. Accordingly, the increase in the electrical resistance value of the first electrode sheet 25 is suppressed.

Moreover, in the embodiment, the conductive adhesive layer 50d and the third conductive cloth 51 are electrically connected. As a result, conduction paths N1 and N3 are formed between the conductive adhesive layer 50d and the third conductive cloth 51, as indicated by arrow signs N1 and N3. Additionally, a conduction path N2 is formed within the layer of the third conductive cloth 51, as indicated by an arrow sign N2. As a result, in the embodiment, a current flows through the conduction paths L1, M1, N1, N2, N3, M3, and L2. Accordingly, the increase in the electrical resistance value of the first electrode sheet 25 is suppressed.

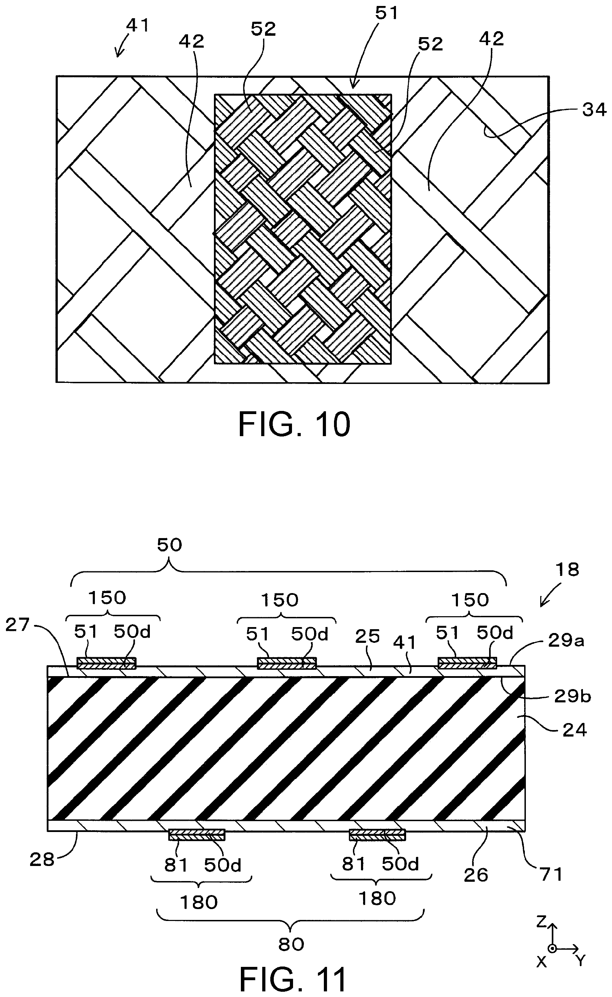

FIG. 10 is a schematic diagram showing the orientation direction of the first yarn 42 of the first conductive cloth 41 and the orientation direction of the third yarn 52 of the third conductive cloth 51. In the embodiment, the first yarn 42 of the first conductive cloth 41 and the third yarn 52 of the third conductive cloth 51 are oriented in the same direction. The expression "same direction" includes the case where the orientation direction of the first yarn 42 of the first conductive cloth 41 and the orientation direction of the third yarn 52 of the third conductive cloth 51 are identical, as well as the case where the orientation directions are not identical but can be considered as substantially the same.

Additionally, the metal forming the third plating layer 54 of the third conductive cloth 51 is the same as the metal forming the first plating layer 44 of the first conductive cloth 41. The expression "same" includes the case where the metal forming the third plating layer 54 of the third conductive cloth 51 is identical to the metal forming the first plating layer 44 of the first conductive cloth 41, as well as the case where the metals are not identical but can be considered as substantially the same in terms of the composition.

Even in the case where the metal forming the third plating layer 54 of the third conductive cloth 51 is not identical to the metal forming the first plating layer 44 of the first conductive cloth 41, the ionization tendency of the metal forming the third plating layer 54 of the third conductive cloth 51 and the metal forming the first plating layer 44 of the first conductive cloth 41 may be the same or substantially the same.

### 8. Second electrode sheet 26

As shown in FIG. 4, at least a portion of the second electrode sheet 26 is embedded on the side of the other surface 28 of the insulator sheet 24. It may be that only a portion of the second electrode sheet 26 is embedded in the insulator sheet 24, or the entire second electrode sheet 26 is embedded in the insulator sheet 24. Additionally, the second electrode sheet 26 may be bonded to the insulator sheet 24 by using a conventional bonding technique, such as a bonding agent or an adhesive, without being embedded in the insulator sheet 24.

The configuration of the second electrode sheet 26 is substantially the same as that of the first electrode sheet 25 in the description of the first electrode sheet 25, except that "first electrode sheet 25" is replaced with "second electrode sheet 26", "first conductive cloth 41" is replaced with "fourth conductive cloth 71", and "first plating layer 44" is replaced with "fourth plating layer 74". Therefore, repeated description will be omitted.

### 9. Third auxiliary member 80

As shown in FIG. 4, the third auxiliary member 80 disposed on the surface on the side opposite to the insulator sheet 24 in the second electrode sheet 26. The third auxiliary member 80 includes a second conductive material 80a that is conductive. The second conductive material 80a and the fourth conductive cloth 71 are electrically connected. The third auxiliary member 80 forms an electrical conduction path at the portion where the fourth plating layer 74 of the fourth conductive cloth 71 is broken.

The third auxiliary member 80 includes a fifth conductive cloth 81. The fifth conductive cloth 81 has a fifth plating layer 84 made of metal on the surface. The fifth conductive cloth 81 is formed of the same material as the fourth conductive cloth 71.

The configuration of the third auxiliary member 80 is substantially the same as that of the first auxiliary member 50 in the description of the configuration of the first auxiliary member 50, except that "first auxiliary member 50" is replaced with "third auxiliary member 80", "third conductive cloth 51" is replaced with "fifth conductive cloth 81", and "third plating layer 54" is replaced with "fifth plating layer 84". Therefore, repeated description will be omitted.

Regarding the lamination direction Z in which the third auxiliary member 80 is laminated on the second electrode sheet 26, the third auxiliary member 80 is disposed at a position overlapping with at least a portion of the first auxiliary member 50. In the embodiment, the third auxiliary member 80 and the first auxiliary member 50 are disposed at overlapped positions in the lamination direction Z.

### 10. Effects of the embodiment

The effects of the embodiment will be described next. The sensor sheet 18 related to the embodiment includes the insulating insulator sheet 24, the first electrode sheet 25, and the first auxiliary member 50. The first electrode sheet 25 is formed by the first conductive cloth 41 having the first plating layer 44 made of metal on the surface. The first electrode sheet 25 is disposed on the surface 27 of the insulator sheet 24. The first auxiliary member 50 includes the first conductive material 50a that is conductive. The first auxiliary member 50 is disposed on a surface of the first electrode sheet 25 in a state in which with the first conductive cloth 41 and the first conductive material 50a are electrically connected, and forms an electrical conduction path at the portion where the first plating layer 44 is broken.

According to the embodiment, even if the first plating layer 44 formed on the first conductive cloth 41 forming the first electrode sheet 25 is broken, by forming the electrical conduction path by using the first conductive material 50a of the first auxiliary member 50, the electrical conduction of the first electrode sheet 25 can be assisted. As a result, the increase in the electrical resistance value of the sensor sheet 18 can be suppressed.

According to the embodiment, the first electrode sheet 25 includes the opening parts 34, which are gaps between multiple first yarns 42 forming the first conductive cloth 41, and at least a portion of the first auxiliary member 50 is positioned inside the opening parts 34.

According to the embodiment, the adhesion between the first electrode sheet 25 and the first auxiliary member 50 is improved, so the electrical contact resistance value between the first electrode sheet 25 and the first auxiliary member 50 can be decreased. As a result, the increase in the electrical resistance value of the sensor sheet 18 can be suppressed.

According to the embodiment, the first auxiliary member 50 is disposed on the first surface 29a of the first electrode sheet 25, which is located on the side opposite to the insulator sheet 24.

The first surface 29a of the first electrode sheet 25 is exposed to the outside because the first surface 29a is located on the opposite side of the insulator sheet 24. Therefore, it is possible that the first surface 29a of the first electrode sheet 25 receives an external force. According to the embodiment, the first surface 29a of the first electrode sheet 25 is protected by the first auxiliary member 50, so the breakage of the first plating layer 44 formed on the first surface 29a of the first electrode sheet 25 due to the external force is suppressed. As a result, the increase in the electrical resistance value of the sensor sheet 18 can be suppressed.

According to the embodiment, each of the multiple first yarns 42 forming the first conductive cloth 41 of the first electrode sheet 25 is formed by the single first fiber 43.

If the first plating layer 44 formed on the single first fiber 43 is broken, the conduction path formed on this first fiber 43 is cut off. In the case where the single first yarn 42 is formed by the single first fiber 43, when the first plating layer 44 formed on the single first fiber 43 is broken, the conduction path formed by the first fiber 43 is also cut off. According to the embodiment, in the case where the single first yarn 42 is formed by the single first fiber 43, even if the first plating layer 44 formed on the single first fiber 43 is broken, the electrical conduction path is formed by the first conductive cloth 41, so the increase in the electrical resistance value of the sensor sheet 18 can be suppressed.

The first electrode sheet 25 according to the embodiment includes the first and second neck parts 25b, 25e narrower than other adjacent portions, and the wide part 25c and the terminal part 25f positioned adjacent to the first and second neck parts 25b, 25e and wider than the first and second neck parts 25b, 25e. The first auxiliary member 50 is disposed in regions including at least a portion of the first and second neck part 25b, 25e in the first electrode sheet 25.

The first and second neck parts 25b, 25e are formed to be narrower than other portions and are therefore prone to deformation by an external force. For this reason, the first electrode sheet 25 disposed at the first and second neck parts 25b, 25e is also prone to deformation. Consequently, the first plating layer 44 formed on the first conductive cloth 41 of the first electrode sheet 25 disposed at the first and second neck parts 25b, 25e is more likely to be broken than other portions. According to the embodiment, even if the first plating layer 44 of the first and second neck parts 25b, 25e is broken, a conduction path is formed by the first auxiliary member 50. Therefore, the electrical resistance value of the sensor sheet 18 can be suppressed from increasing.

According to the embodiment, the first auxiliary member 50 is disposed to straddle the first to second neck parts 25b, 25e and the wide part 25c and the terminal part 25f Stress tends to concentrate at the boundary portions between the first to second neck parts 25b, 25e that are easily deformable and the wide part 25c and the terminal part 25f that are less deformable than the neck part. As a result, the first plating layer 44 of the first electrode sheet 25 is more likely to be broken at the boundary portions between the first to second neck parts 25b, 25e and the wide part 25c and the terminal part 25f. According to the embodiment, since the first auxiliary member 50 is disposed to straddle the first to second neck part 25b, 25e and the wide part 25c and the terminal part 25f, a conduction path can be formed even in the case where the first plating layer 44 is broken at the boundary portions between the first to second neck part 25b, 25e and the wide part 25c, the terminal part 25f. As a result, the increase in the electrical resistance value of the sensor sheet 18 can be suppressed.

The first electrode sheet 25 according to the embodiment includes the body part 25a elongated in the longitudinal direction X. The first neck part 25b is formed narrower in the cross direction crossing the longitudinal direction X in the body part 25a.

Even in the case where the first plating layer 44 of the first electrode sheet 25 is broken at the first neck part 25b, a conduction path is formed by the first auxiliary member 50, so the decrease in the electrical resistance value of the first electrode sheet 25 is suppressed.

The first electrode sheet 25 according to the embodiment includes the body part 25a formed elongated in the longitudinal direction X, and the extension part 25d extending from the body part 25a in the direction intersecting with the longitudinal direction X. The terminal part 25f, which is connected to an external circuit, is formed at a a position near the tip of the extension part 25d. The second neck part 25e is formed in the extension part 25d between the body part 25a and the terminal part 25f.

For example, an external force may be applied to the terminal part 25f during a process of connecting the terminal part 25f and an external circuit or a process of wiring the electric wire 32 related to the external circuit. The external force applied to the terminal part 25f tends to concentrate on the second neck part 25e. When the stress concentrates on the second neck part 25e, there is a risk that the first plating layer 44 disposed on the second neck part 25e may be broken. According to the embodiment, even in the case where the first plating layer 44 of the second neck part 25e is broken, a conduction path is formed by the first auxiliary member 50. Therefore, the electrical resistance value of the sensor sheet 18 can be suppressed from increasing.

According to the embodiment, the insulator sheet 24 is formed by an elastomer, and at least a portion of the first electrode sheet 25 and at least a portion of the first auxiliary member 50 are embedded in the elastomer. This can improve the adhesion strength between the insulator sheet 24 and the first electrode sheet 25.

The first conductive material 50a of the first auxiliary member 50 according to the embodiment may be configured to include the same metal as the metal forming the first plating layer 44 formed on the first conductive cloth 41 of the first electrode sheet 25. In such case, the occurrence of electrolytic corrosion between the metal forming the first plating layer 44 of the first conductive cloth 41 of the first electrode sheet 25 and the metal included in the first conductive material 50a of the first auxiliary member 50 can be suppressed.

The first conductive material 50a of the first auxiliary member 50 according to the embodiment may be configured to include conductive carbon or graphite. In such case, since the first conductive material 50a of the first auxiliary member 50 is configured without containing metal, the occurrence of electrolytic corrosion in the first conductive material 50a of the first auxiliary member 50 can be suppressed.

The first conductive material 50a of the first auxiliary member 50 according to the embodiment is a laminate of the conductor layer 50b including a conductor, and the conductive bonding layer containing a conductive filler and a curable resin, or the conductive adhesive layer 50d containing a conductive filler and a binder resin. According to the embodiment, an electrical conduction path can be formed at a portion where the first plating layer 44 is broken by using the conductor layer 50b or the conductive adhesive layer 50d. As a result, even in the case where either the conductor layer 50b or the conductive adhesive layer 50d is electrically cut off, the increase in the electrical resistance value of the first electrode sheet 25 can be suppressed.

The conductor layer 50b of the first conductive material 50a according to the embodiment is formed by the third conductive cloth 51 having the third plating layer 54 made of metal on the surface. The metal forming the third plating layer 54 of the third conductive cloth 51 is the same as the metal forming the first plating layer 44 of the first conductive cloth 41. Accordingly, the occurrence of electrolytic corrosion between the first plating layer 44 of the first conductive cloth 41 and the third plating layer 54 of the third conductive cloth can be suppressed.

The third yarn 52 forming the third conductive cloth 51 according to the embodiment is either a twisted wire in which multiple third fibers 53 are twisted, or a non-twisted yarn bundle wire in which multiple third fibers 53 are bundled without being twisted. As a result, even in the case where any of the third fibers 53 is electrically cut off, a conduction path is formed by other third fibers 53. Therefore, the increase in the electrical resistance value of the first electrode sheet 25 can be suppressed.

According to the embodiment, the first yarn 42 forming the first conductive cloth 41 is formed by the first fiber 43, and the third yarn 52 forming the third conductive cloth 51 is formed by the third fiber 53, and the diameter of the third fiber 53 is smaller than the diameter of the first fiber 43. According to the embodiment, since the diameter of the third fiber 53 is smaller than the diameter of the first fiber 43, the third conductive cloth 51 formed by the third fiber 53 is more flexible than the first conductive cloth 41. Therefore, by flexibly deforming the third conductive cloth 51 along the shape of the first conductive cloth 41, the adhesion between the first conductive cloth 41 and the third conductive cloth 51 can be improved. As a result, the third conductive cloth 51 can reliably form a conduction path for backing up the first conductive cloth 41, so the increase in the electrical resistance value of the sensor sheet 18 can be suppressed.

According to the embodiment, the yarn forming the first conductive cloth 41 of the first electrode sheet 25 and the yarn forming the third conductive cloth 51 of the first auxiliary member 50 are oriented in the same direction.

The conduction path of the first conductive cloth 41 is formed along the first yarn 42 forming the first conductive cloth 41. Additionally, the conduction path of the third conductive cloth 51 is formed along the third yarn 52 forming the third conductive cloth 51. In the embodiment, since the first yarn 42 and the third yarn 52 are oriented in the same direction, the conduction path of the third conductive cloth 51 is formed along the conduction path of the first conductive cloth 41. In other words, in the sensor sheet 18 of the embodiment, a backup conduction path using the third conductive cloth 51 is formed along each conduction path of the first conductive cloth 41. As a result, in the case where the first plating layer 44 of the first yarn 42 of the first conductive cloth 41 is broken, a conduction path along the yarn of the first conductive cloth 41 from which the first plating layer 44 has peeled off can be formed by using the third yarn 52 of the third conductive cloth 51. Therefore, the increase in the electrical resistance value of the sensor sheet 18 can be suppressed.

The thickness dimension of the first auxiliary member 50 according to the embodiment is smaller than the thickness dimension of the first electrode sheet 25. As a result, the first auxiliary member 50 is more easily deformed in accordance with the shape of the first electrode sheet 25. Consequently, the adhesion between the first auxiliary member 50 and the first electrode sheet 25 is improved, so even in the case where the first plating layer 44 of the first electrode sheet 25 is broken, a conduction path can be reliably formed by the first auxiliary member 50.

The first electrode sheet 25 of the embodiment is formed in an elongated shape in the longitudinal direction X, and the elastic modulus of the first auxiliary member 50 in the longitudinal direction X is larger than the elastic modulus of the first electrode sheet 25 in the longitudinal direction X. According to the embodiment, the first electrode sheet 25 can be reinforced by the first auxiliary member 50. As a result, a damage to the first electrode sheet 25 due to an external force can be suppressed.

According to the embodiment, the first electrode sheet 25 is formed in an elongated shape in the longitudinal direction X, and the bending strength of the first auxiliary member 50 when bent along a folding line in a direction crossing the longitudinal direction X in the plane of the first auxiliary member 50 is larger than the bending strength of the first electrode sheet 25 when bent along a folding line in a direction crossing the longitudinal direction X in the plane of the first electrode sheet 25. According to the embodiment, the first electrode sheet 25 can be reinforced by the first auxiliary member 50. As a result, a damage to the first electrode sheet 25 due to an external force can be suppressed.

The first electrode sheet 25 according to the embodiment is formed in an elongated shape in the longitudinal direction X, and the electrical resistivity of the first auxiliary member 50 in the longitudinal direction X is the same as or smaller than the electrical resistivity of the first electrode sheet 25 in the longitudinal direction X. According to the embodiment, the electrical resistivity of the conduction path formed by the first auxiliary member 50 can be made the same as or smaller than the electrical resistivity of the first electrode sheet 25, so an increase in the electrical resistance value of the sensor sheet 18 can be suppressed.

The sensor sheet 18 according to the embodiment includes the second electrode sheet 26 and the third auxiliary member 80. The second electrode sheet 26 is formed by the fourth conductive cloth 71 having the fourth plating layer 74 made of metal on the surface and is disposed on the other surface of the insulator sheet 24. The third auxiliary member 80 includes the second conductive material 80a that is conductive, is disposed in a state in which the fourth conductive cloth 71 and the second conductive material 80a are electrically connected, and the third auxiliary member 80 forms an electrical conduction path of the portion where the fourth plating layer 74 is broken. According to the embodiment, the second electrode sheet 26 can be used, for example, as a sensor electrode or a shield electrode paired with the first electrode sheet 25, or can be used as a heater. Therefore, the functionality of the sensor sheet 18 can be improved.

According to the embodiment, regarding the lamination direction Z in which the third auxiliary member 80 is laminated on the second electrode sheet 26, the third auxiliary member 80 is disposed at a position overlapping with at least a portion of the first auxiliary member 50. By forming a portion where the third auxiliary member 80 and the first auxiliary member 50 overlap in a portion where the sensor sheet 18 is greatly bent or where a large force is applied to the sensor sheet 18, an electrical conduction path can be formed in the portion where the first plating layer 44 of the first electrode sheet 25 or the fourth plating layer 74 of the second electrode sheet 26 is broken.

The third auxiliary member 80 of the embodiment includes the fifth conductive cloth 81 having the fifth plating layer 84 made of metal on the surface. The fifth conductive cloth 81 can form an electrical conduction path in the portion where the fourth plating layer 74 of the second electrode sheet 26 is broken.

The fifth conductive cloth 81 according to the embodiment is formed of the same material as the fourth conductive cloth 71. According to the embodiment, the fifth conductive cloth 81 and the fourth conductive cloth 71 can be formed of the same material, so the manufacturing cost of the sensor sheet 18 can be reduced. In addition, it is possible to suppress the occurrence of electrolytic corrosion between the fifth plating layer 84 of the fifth conductive cloth 81 and the fourth plating layer 74 of the fourth conductive cloth 71.

### (Embodiment 2)

Next, Embodiment 2 will be described with reference to FIG. 11. The first auxiliary member 50 of the embodiment is formed by multiple first split auxiliary members 150 disposed at intervals. The direction in which the multiple first split auxiliary members 150 are disposed is arbitrary, and may be disposed at intervals in the longitudinal direction X, or disposed at intervals in the cross direction Y.

The third auxiliary member 80 of the embodiment is formed by multiple third split auxiliary members 180 disposed at intervals. The direction in which the multiple third split auxiliary members 180 are disposed is arbitrary, and may be disposed at intervals in the longitudinal direction X, or disposed at intervals in the cross direction Y.

The third auxiliary member 80 of the embodiment is disposed in a position that does not overlap with the first auxiliary member 50 in the lamination direction Z.

In Embodiment 2 and subsequent embodiments, reference numerals that are identical to those used in the previously described embodiments represent the same or similar components as in the previously described embodiments, unless otherwise specified.

The effects of the embodiment will be described next. The first auxiliary member 50 of the embodiment is the first split auxiliary members 150 disposed at intervals. As a result, it is possible to form a conduction path for a portion where the first electrode sheet 25 is greatly bent locally, or a portion where a large force is locally applied to the first electrode sheet 25.

According to the embodiment, in the lamination direction Z where the third auxiliary member 80 is laminated on the second electrode sheet 26, the third auxiliary member 80 is disposed in a position that does not overlap with the first auxiliary member 50. As a result, it is possible to suppress the increase in the electrical resistance value of the sensor sheet 18 without affecting the flexibility of the sensor sheet 18.

### (Embodiment 3)

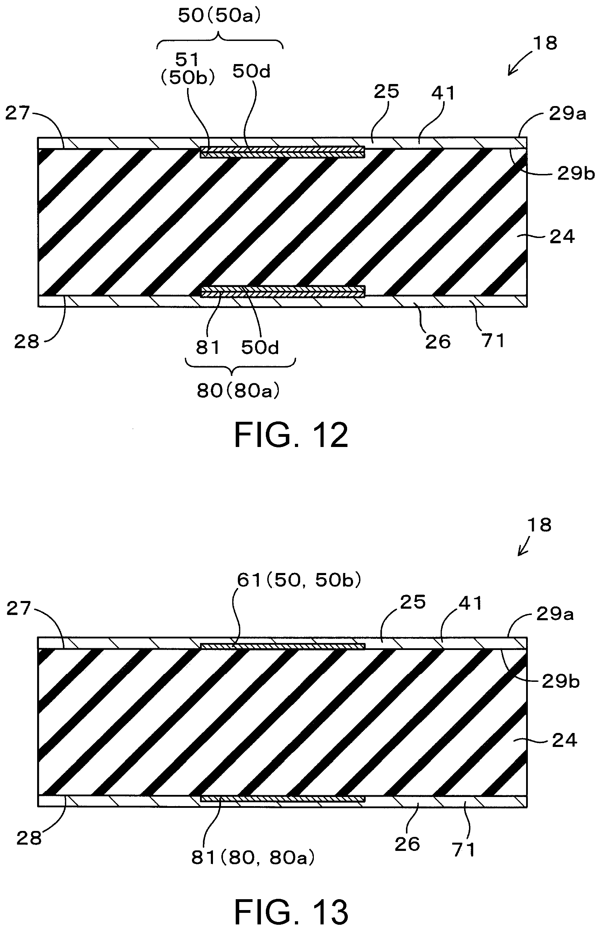

Next, Embodiment 3 will be described with reference to FIG. 12. The first auxiliary member 50 of the embodiment is disposed on a second surface 29b of the first electrode sheet 25 positioned on the side of the insulator sheet 24.

Additionally, the third auxiliary member 80 of the embodiment is disposed on the surface of the second electrode sheet 26 on the side of the insulator sheet 24.

The first auxiliary member 50 is disposed between the first electrode sheet 25 and the insulator sheet 24, making it less susceptible to damage from external force. Therefore, even if the first plating layer 44 of the first electrode sheet 25 is broken due to external force, a conduction path can be formed by the first auxiliary member 50. As a result, the increase in the electrical resistance value of the sensor sheet 18 can be suppressed.

### (Embodiment 4)

Next, Embodiment 4 will be described with reference to FIGs. 13 to 14. The first auxiliary member 50 of the embodiment includes a second conductive cloth 61. The second conductive cloth 61 has a second plating layer 64 made of metal on the surface. The second conductive cloth 61 is disposed on the second surface 29b of the first electrode sheet 25. However, the second conductive cloth 61 may also be disposed on the first surface 29a of the first electrode sheet 25.

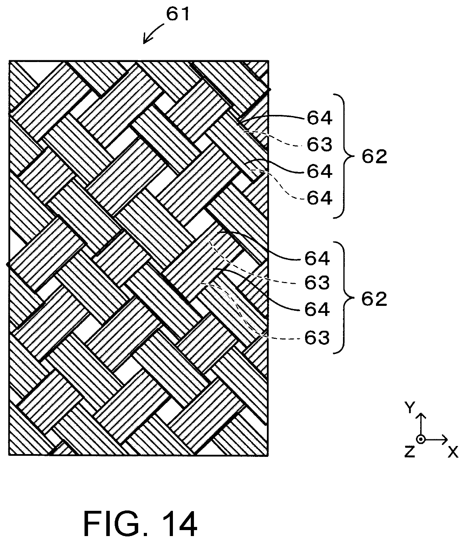

As shown in FIG. 14, the second conductive cloth 61 of the embodiment includes multiple second yarns 62. The second conductive cloth 61 according to the embodiment is formed of the same material as the first conductive cloth 41. However, the second conductive cloth 61 and the first conductive cloth 41 may be formed of different materials.

The metal forming the second plating layer 64 formed on the second conductive cloth 61 of the embodiment is the same as the metal forming the first plating layer 44 formed on the first electrode sheet 25.

The configuration of the second conductive cloth 61 of the embodiment is substantially the same as that of the first auxiliary member 50, except that in the description of the first auxiliary member 50 described in FIG. 8 of Embodiment 1, the third conductive cloth 51 is replaced with the second conductive cloth 61, the third yarn 52 is replaced with the second yarn 62, and the third fiber 53 is replaced with the second fiber 63. Therefore, repeated description will be omitted. It should be noted that the second conductive cloth 61 of the embodiment is configured without including the conductive adhesive layer 50d in the first auxiliary member 50 described in Embodiment 1.

The elastomer forming the insulator sheet 24 penetrates into the opening part 34 of the first conductive cloth 41 forming the first electrode sheet 25. At least a portion of the first auxiliary member 50 is embedded in the elastomer. Specifically, the elastomer forming the insulator sheet 24 penetrates into the gaps between the second yarns 62 forming the second conductive cloth 61. Accordingly, the first electrode sheet 25 and the first auxiliary member 50 are fixed integrally with the insulator sheet 24.

In addition, in the embodiment, the third auxiliary member 80 is formed by a fifth conductive cloth 81 having a fifth plating layer 84 made of metal on the surface. The third auxiliary member 80 is arranged on the surface of the second electrode sheet 26 on the side of the insulator sheet 24. However, the third auxiliary member 80 may also be disposed on the side to the insulator sheet 24 in the second electrode sheet 26.

In the embodiment, although not shown in detail, the elastomer forming the insulator sheet 24 penetrates into the opening part of the fourth conductive cloth 71 forming the second electrode sheet 26. At least a portion of the third auxiliary member 80 is embedded in the elastomer. Specifically, the elastomer forming the insulator sheet 24 penetrates into the gaps between the fifth yarns 82 forming the fifth conductive cloth 81 of the third auxiliary member 80. Accordingly, the second electrode sheet 26 and the third auxiliary member 80 are fixed integrally with the insulator sheet 24.

The third auxiliary member 80 may be formed flush with the surface on the side opposite to the insulator sheet 24 in the second electrode sheet 26, or may also be formed to bulge from the surface opposite to the insulator sheet 24 in the second electrode sheet 26. It should be noted that the third auxiliary member 80 includes the fifth conductive cloth 81. The configuration of the fifth conductive cloth 81 is substantially the same as that of the second conductive cloth 61 described above, so repeated description will be omitted.

The first auxiliary member 50 according to the embodiment is formed by the second conductive cloth 61 having the second plating layer 64 made of metal on the surface. According to the embodiment, a conduction path is formed without a conductive adhesive layer 91 or a conductive adhesive 92, etc., through the contact between the first conductive cloth 41 forming the first electrode sheet 25 and the second conductive cloth 61 forming the first auxiliary member 50. As a result, the increase in the electrical resistance value of the sensor sheet 18 can be suppressed.

The second conductive cloth 61 according to the embodiment is formed of the same material as the first conductive cloth 41. According to the embodiment, the first conductive cloth 41 and the second conductive cloth 61 can be formed of the same material, so the manufacturing cost of the sensor sheet 18 can be reduced. In addition, it is possible to suppress the occurrence of electrolytic corrosion between the first plating layer 44 of the first conductive cloth 41 and the second plating layer 64 of the second conductive cloth 61.

In the embodiment, the second yarn 62 forming the second conductive cloth 61 is either a twisted wire in which multiple second fibers 63 are twisted, or a non-twisted yarn bundle wire in which multiple second fibers 63 are bundled without being twisted. According to the embodiment, a conduction path is formed by multiple fibers. Therefore, even in the case where the second plating layer 64 is broken in the fibers forming the second conductive cloth 61, there is a high possibility that the conduction path remains. As a result, the increase in the electrical resistance value of the sensor sheet 18 can be suppressed.

In the embodiment, the first yarn 42 forming the first conductive cloth 41 is formed the first fiber 43, the second yarn 62 forming the second conductive cloth 61 is formed of the second fiber 63, and the diameter of the second fiber 63 may be smaller than the diameter of the first fiber 43.

According to the embodiment, since the diameter of the second fiber 63 is smaller than the diameter of the first fiber 43, the second conductive cloth 61 formed by the second fiber 63 is more flexible than the first conductive cloth 41. Therefore, by flexibly deforming the second conductive cloth 61 along the shape of the first conductive cloth 41, the adhesion between the first conductive cloth 41 and the third conductive cloth 61 can be improved. As a result, the second conductive cloth 61 can reliably form a conduction path for backing up the first conductive cloth 41, so the increase in the electrical resistance value of the sensor sheet 18 can be suppressed.

In the embodiment, the first yarn 42 forming the first conductive cloth 41 of the first electrode sheet 25 and the second yarn 62 forming the second conductive cloth 61 of the first auxiliary member 50 may be oriented in the same direction.

The conduction path of the first conductive cloth 41 is formed along the first yarn 42 forming the first conductive cloth 41. Additionally, the conduction path of the second conductive cloth 61 is formed along the second yarn 62 forming the second conductive cloth 61. In the embodiment, since the first yarn 42 and the second yarn 62 are oriented in the same direction, the conduction path of the third conductive cloth 61 is formed along the conduction path of the first conductive cloth 41. In other words, in the sensor sheet 18 of the embodiment, a backup conduction path using the second conductive cloth 61 is formed along each conduction path of the first conductive cloth 41. As a result, in the case where the first plating layer 44 of the yarn of the first conductive cloth 41 is broken, a conduction path along the yarn of the first conductive cloth 41 from which the first plating layer 44 has peeled off can be formed by using the yarn of the second conductive cloth 61. Therefore, the increase in the electrical resistance value of the sensor sheet 18 can be suppressed.

### (Embodiment 5)

Next, Embodiment 5 will be described with reference to FIGs. 15A and B. FIG. 15A illustrates a modified example (1) of Embodiment 5. The first conductive material 50a of the first auxiliary member 50 in the modified (1) differs from Embodiment 1 in that it does not include the third conductive cloth 51. In other words, the first conductive material 50a of the embodiment is formed only by the conductive adhesive layer 91 including a conductive filler and a binder resin. Additionally, the first conductive material 50a may also be a conductive adhesive 92 including a conductive filler and a curable resin. Furthermore, the first conductive material 50a may be a conductive paste 93 including a conductive filler and a binder resin. As the curable resin and the adhesive are the same as in Embodiment 1, repeated description will be omitted. As the binder resin, conventional binder resins such as a silicone-based resin can be appropriately selected.

As shown in FIG. 15A, the first auxiliary member 50 of the embodiment is disposed on the first surface 29a of the first electrode sheet 25. In the embodiment, the first auxiliary member 50 is formed to bulge from the first surface 29a of the first electrode sheet 25. However, the first auxiliary member 50 may be formed flush with the first surface 29a of the first electrode sheet 25. Additionally, the first auxiliary member 50 may be disposed by being laminated with the first surface 29a of the first electrode sheet 25.

As shown in FIG. 15A, the third auxiliary member 80 of the embodiment is positioned on the surface on the side opposite to the insulator sheet 24 in the second electrode sheet 26. In the embodiment, the third auxiliary member 80 is formed to bulge from the surface on the side opposite to the insulator sheet 24 in the second electrode sheet 26. However, the third auxiliary member 80 may be formed flush with, or laminated on, the surface on the side opposite to the second insulator sheet 24 in the second electrode sheet 26. The second conductive material 80a forming the third auxiliary member 80 may be the conductive adhesive layer 91, the conductive adhesive 92, or the conductive paste 93.

In addition, FIG. 15B illustrates a modified example (2) of Embodiment 5. The first auxiliary member 50 of the modified example (2) is disposed on the second surface 29b of the first electrode sheet 25.

As shown in FIG. 15B, the third auxiliary member 80 of the embodiment is positioned on the surface on the side of the insulator sheet 24 in the second electrode sheet 26.

The first conductive material 50a of the first auxiliary member 50 according to the embodiment may be the conductive adhesive layer 91 including a conductive filler and a binder resin, the conductive adhesive 92 including a conductive filler and a curable resin, or the conductive paste 93 including a conductive filler and a binder resin. As a result, it is possible to suppress an increase in the electrical resistance value of the sensor sheet 18 without reducing the flexibility of the sensor sheet 18.

### (Embodiment 6)

Next, Embodiment 6 will be described with reference to FIGs. 16A to 16C. As shown in FIG. 16A, in a modified example (1) of Embodiment 6, the first auxiliary member 50 is disposed on the first surface 29a of the first electrode sheet 25, and a second auxiliary member 100 is disposed on the second surface 29b of the first electrode sheet 25.

The second auxiliary member 100 includes a second conductive material 80a. The second conductive material 80a and the first conductive cloth 41 are electrically connected. The second auxiliary member 100 forms an electrical conduction path at the portion where the first plating layer 44 of the first conductive cloth 41 is broken. The second auxiliary member 100 includes a sixth conductive cloth 101 and a conductive adhesive layer 50d. The configuration of the second auxiliary member 100 is substantially the same as that of the first auxiliary member 50 described earlier, except that the third conductive cloth 51 is replaced with the sixth conductive cloth 101. Therefore, repeated description will be omitted.

As shown in FIG. 16A, in the modification example (1) of Embodiment 6, the second auxiliary member 100 is disposed at a position overlapping with at least a portion of the first auxiliary member 50 in the lamination direction Z in which the first auxiliary member 50 is laminated on the first electrode sheet 25. In the modified example (1), the second auxiliary member 100 is disposed at a position overlapping with the first auxiliary member 50 in the lamination direction Z.

As shown in FIG. 16B, in a modified example (2) of Embodiment 6, the first auxiliary member 50 is formed by the first split auxiliary members 150 disposed at intervals. Additionally, the second auxiliary member 100 according to the modified example (2) is formed by the second split auxiliary members 160 arranged at intervals. The first split auxiliary members 150 and the second split auxiliary members 160 are disposed at positions not overlapping with each other in the lamination direction Z.

As shown in FIG. 16C, in a modified example (3) of Embodiment 6, the first auxiliary member 50 is formed by the first split auxiliary members 150 disposed at intervals. Additionally, the second auxiliary member 100 according to the modified example (2) is formed by the second split auxiliary members 160 arranged at intervals. The first split auxiliary members 150 and the second split auxiliary members 160 are disposed at positions not overlapping with each other in the lamination direction Z. In the embodiment, the second split auxiliary members 160 are formed slightly larger than the first split auxiliary members 150. However, the first split auxiliary members 150 may be formed slightly larger than the second split auxiliary members 160, or the first split auxiliary members 150 and the second split auxiliary members 160 may be of the same size.

As shown in FIG. 16A, in the embodiment of the sensor sheet 18, the second auxiliary member 100 may be disposed at a position overlapping with the first auxiliary member 50 in the lamination direction Z in which the first auxiliary member 50 is laminated on the first electrode sheet 25. Accordingly, a conduction path is reliably formed by the first auxiliary members 50, and a conduction path is formed by the second auxiliary members 50. As a result, the increase in the electrical resistance value of the sensor sheet 18 can be further suppressed.

As shown in FIG. 16B, in the embodiment of the sensor sheet 18, the second auxiliary member 100 may be disposed at a position not overlapping with the first auxiliary member 50 in the lamination direction Z in which the first auxiliary member 50 is laminated on the first electrode sheet 25. By disposing the first auxiliary member 50 and the second auxiliary member 100 to not overlap with each other in the lamination direction Z, it is possible to suppress the increase in the electrical resistance value of the sensor sheet 18 without affecting the flexibility of the sensor sheet 18.

As shown in FIG. 16C, in the embodiment of the sensor sheet 18, the second auxiliary member 100 may be disposed at a position at least partially overlapping with the first auxiliary member 50 in the lamination direction Z in which the first auxiliary member 50 is laminated on the first electrode sheet 25. In the region where the first auxiliary member 50 and the second auxiliary member 100 overlap in the lamination direction Z, the conduction path of the first electrode sheet 25 is secured by both the first auxiliary member 50 and the second auxiliary member 100. As a result, the increase in the electrical resistance value of the sensor sheet 18 can be further suppressed.

As shown in FIGs. 16B and 16C, the second auxiliary member 100 according to the configuration includes the second split auxiliary members 160 discretely disposed at intervals. As a result, it is possible to form a conduction path for a portion where the first electrode sheet 25 is greatly bent locally, or a portion where a large force is locally applied to the first electrode sheet 25.

The disclosure is not limited to the above-described embodiments, and can be applied to various embodiments within the scope of the appended claims.

## Claims

1. A sensor sheet (18), comprising:
an insulating sheet (24) that is insulating;
a first electrode sheet (25), formed by using a first conductive cloth (41) that has, on a surface, a first plating layer (44) made of metal, and disposed on a surface of the insulator sheet; and
a first auxiliary member (50), comprising a first conductive material (50a) that is conductive, disposed on a surface of the first electrode sheet in a state in which the first conductive cloth and the first conductive material are electrically connected, and forming an electrical conduction path at a portion where the first plating layer is broken,
wherein the sensor sheet (18) is **characterized in that**
the first auxiliary member is formed by a second conductive cloth (61) having, on a surface, a second plating layer (64) made of metal.

2. The sensor sheet as claimed in claim 1, wherein the first electrode sheet comprises an opening part (34) that is a gap between a plurality of yarns forming the first conductive cloth, and at least a portion of the first auxiliary member is disposed inside the first opening part.

3. The sensor sheet as claimed in claim 1, wherein the first auxiliary member is disposed on a first surface (29a) located on a side opposite to the insulator sheet in the first electrode sheet.

4. The sensor sheet as claimed in claim 1, wherein the first auxiliary member is disposed on a second surface (29b) located on a side of the insulator sheet in the first electrode sheet.

5. The sensor sheet as claimed in claim 1, wherein each of a plurality of yarns forming the first conductive cloth of the first electrode sheet is formed by one fiber.

6. The sensor sheet as claimed in claim 1, further comprising: a second auxiliary member (100),
wherein the second auxiliary member comprises a second conductive material (80a) that is conductive, is disposed, on an other surface on a side opposite to the surface of the first electrode sheet, in a state in which the first conductive cloth and the second conductive material are electrically connected, and forms an electrical conduction path at a portion where the first plating layer is broken.

7. The sensor sheet as claimed in claim 6, wherein in a lamination direction in which the first auxiliary member is laminated on the first electrode sheet, the second auxiliary member is disposed at a position overlapping with at least a portion of the first auxiliary member.

8. The sensor sheet as claimed in claim 6, wherein in a lamination direction in which the first auxiliary member is laminated on the first electrode sheet, the second auxiliary member is disposed at a position not overlapping with the first auxiliary member.

9. The sensor sheet as claimed in claim 1, wherein the first auxiliary member is a plurality of first split auxiliary member (150) disposed at intervals.

10. The sensor sheet as claimed in claim 6, wherein the second auxiliary member is a plurality of second split auxiliary member (160) discretely disposed at intervals.

11. The sensor sheet as claimed in claim 1, wherein the first electrode sheet comprises a neck part (25b, 25e) narrower than other adjacent portions and a wide part (25c) disposed adjacent to the neck part and wider than the neck part, and
the first auxiliary member is disposed in a region comprising at least a portion of the neck part in the first electrode sheet.

12. The sensor sheet as claimed in claim 11, wherein the first auxiliary member is disposed to straddle the neck part and the wide part.

13. The sensor sheet as claimed in claim 11, wherein the first electrode sheet comprises a body part (25a) elongated in a longitudinal direction, and
the neck part is formed, in the body part, to be narrow in a cross direction crossing the longitudinal direction.

14. The sensor sheet as claimed in claim 11, wherein the first electrode sheet comprises:
a body part, formed to be elongated in a longitudinal direction; and
an extension part (25d), extending in a direction crossing the longitudinal direction from the body part,
wherein a terminal part (25f) connected with an external circuit is formed at a position near a tip of the extension part, and
the neck part is formed, in the extension part, between the body part and the terminal part.

15. The sensor sheet as claimed in claim 1, wherein the second conductive cloth is formed of a same material as the first conductive cloth.

16. The sensor sheet as claimed in claim 1, wherein a second yarn (62) forming the second conductive cloth is a twisted wire in which a plurality of second fibers (63) are twisted or a non-twisted yarn bundle wire in which the second fibers are bundled without being twisted.

17. The sensor sheet as claimed in claim 1, wherein a first yarn (42) forming the first conductive cloth is formed by a first fiber (43),
a second yarn forming the second conductive cloth is formed by a second fiber, and
a diameter of the second fiber is smaller than a diameter of the first fiber.

18. The sensor sheet as claimed in claim 1, wherein a first yarn forming the first conductive cloth of the first electrode sheet and a second yarn forming the second conductive cloth of the first auxiliary member are oriented in a same direction.

19. The sensor sheet as claimed in claim 1, wherein the insulator sheet is formed by an elastomer, and
at least a portion of the first electrode sheet and at least a portion of the first auxiliary member are embedded in the elastomer.

20. The sensor sheet as claimed in claim 1, wherein the first conductive material of the first auxiliary member is a conductive adhesive (92) comprising a conductive filler and a curable resin.

21. The sensor sheet as claimed in claim 1, wherein the first conductive material of the first auxiliary member is a conductive adhesive (50d) comprising a conductive filler and an adhesive.

22. The sensor sheet as claimed in claim 1, wherein the first conductive material of the first auxiliary member is a conductive paste (93) comprising a conductive filler and a binder resin.

23. The sensor sheet as claimed in claim 1, wherein the first conductive material of the first auxiliary member comprises metal same as the metal forming the first plating layer formed on the first conductive cloth of the first electrode sheet.

24. The sensor sheet as claimed in claim 1, wherein the first conductive material of the first auxiliary member is conductive carbon or graphite.

25. The sensor sheet as claimed in claim 1, wherein the first conductive material of the first auxiliary member is a laminate of:
a conductor layer (50b), comprising a conductor body; and
a conductive binding layer comprising a conductive filler and a curable resin or a conductive adhesive layer (50d) comprising a conductive filler and a binder resin.

26. The sensor sheet as claimed in claim 25, wherein the conductor layer is formed by a third conductive cloth (51) having, on a surface, a third plating layer (54) made of metal.

27. The sensor sheet as claimed in claim 26, wherein the metal forming the third plating layer of the third conductive cloth is same as the metal forming the first plating layer of the first conductive cloth.

28. The sensor sheet as claimed in claim 26, wherein a third yarn (52) forming the third conductive cloth is a twisted wire in which a plurality of third fibers (53) are twisted or a non-twisted yarn bundle wire in which the third fibers are bundled without being twisted.

29. The sensor sheet as claimed in claim 26, wherein a first yarn forming the first conductive cloth is formed by a first fiber,
a third yarn forming the third conductive cloth is formed by a third fiber, and
a diameter of the third fiber is smaller than a diameter of the first fiber.

30. The sensor sheet as claimed in claim 26, wherein a yarn forming the first conductive cloth of the first electrode sheet and a yarn forming the third conductive cloth of the first auxiliary member are oriented in a same direction.

31. The sensor sheet as claimed in claim 1, wherein a thickness dimension of the first auxiliary member is smaller than a thickness dimension of the first electrode sheet.

32. The sensor sheet as claimed in claim 1, wherein the first electrode sheet is formed to be elongated in a longitudinal direction, and
an elastic modulus of the first auxiliary member in the longitudinal direction is greater than an elastic modulus of the first electrode sheet in the longitudinal direction.

33. The sensor sheet as claimed in claim 1, wherein the first electrode sheet is formed to be elongated in a longitudinal direction, and
a bending strength of the first auxiliary member when the first auxiliary member is bent by using a fold line in a direction crossing the longitudinal direction in a plane of the first auxiliary member is greater than a bending strength of the first electrode sheet when the first electrode sheet is bent by using a fold line in a direction crossing the longitudinal direction in a plane of the first electrode sheet.

34. The sensor sheet as claimed in claim 1, wherein the first electrode sheet is formed to be elongated in a longitudinal direction, and
an electric resistivity of the first auxiliary member in the longitudinal direction is same as or smaller than an electric resistivity of the first electrode sheet in the longitudinal direction.

35. The sensor sheet as claimed in claim 1, further comprising:
a second electrode sheet (26), formed by using a fourth conductive cloth (71) that has, on a surface, a fourth plating layer (74) formed of metal, and disposed on an other surface of the insulator sheet; and
a third auxiliary member (80), comprising a second conductive material (80a) that is conductive, is disposed, on a surface of the second electrode sheet, in a state in which the fourth conductive cloth and the second conductive material are electrically connected, and forms an electrical conduction path at a portion where the fourth plating layer is broken.

36. The sensor sheet as claimed in claim 35, wherein, in a lamination direction in which the third auxiliary member is laminated on the second electrode sheet, the third auxiliary member is disposed at a position overlapping with at least a portion of the first auxiliary member.

37. The sensor sheet as claimed in claim 35, wherein in a lamination direction in which the third auxiliary member is laminated on the second electrode sheet, the third auxiliary member is disposed at a position not overlapping with the first auxiliary member.

38. The sensor sheet as claimed in claim 35, wherein the third auxiliary member comprises a fifth conductive cloth (81) that has, on a surface, a fifth plating layer (84) made of metal.

39. The sensor sheet as claimed in claim 38, wherein the fifth conductive cloth is formed of a same material as the fourth conductive cloth.

## Patentansprüche

1. Sensorschicht (18), umfassend:
eine Isolierschicht (24), die isolierend ist;
eine erste Elektrodenschicht (25), die unter Verwendung eines ersten leitfähigen Gewebes (41) gebildet ist, das auf einer Oberfläche eine aus Metall hergestellte erste Metallschicht (44), und auf einer Oberfläche der Isolierschicht angeordnet ist; und
ein erstes Hilfselement (50), das ein erstes leitfähiges Material (50a) umfasst, das leitfähig ist, auf einer Oberfläche der ersten Elektrodenschicht in einem Zustand angeordnet ist, in dem das erste leitfähige Gewebe und das erste leitfähige Material elektrisch verbunden sind, und einen elektrischen Leitungsweg an einem Abschnitt bildet, an dem die erste Metallschicht unterbrochen ist,
wobei die Sensorschicht (18) **dadurch gekennzeichnet ist, dass**
das erste Hilfselement durch ein zweites leitfähiges Gewebe (61) gebildet ist, das auf einer Oberfläche eine aus Metall hergestellte zweite Metallschicht (64) aufweist.

2. Sensorschicht nach Anspruch 1, wobei die erste Elektrodenschicht einen Öffnungsabschnitt (34) umfasst, der einen Spalt zwischen einer Vielzahl von Garnen bildet, die das erste leitfähige Gewebe bilden, und zumindest ein Abschnitt des ersten Hilfselements innerhalb des ersten Öffnungsabschnitts angeordnet ist.

3. Sensorschicht nach Anspruch 1, wobei das erste Hilfselement auf einer ersten Oberfläche (29a) angeordnet ist, die sich auf einer der Isolierschicht gegenüberliegenden Seite in der ersten Elektrodenschicht befindet.

4. Sensorschicht nach Anspruch 1, wobei das erste Hilfselement auf einer zweiten Oberfläche (29b) angeordnet ist, die sich auf einer Seite der Isolierschicht in der ersten Elektrodenschicht befindet.

5. Sensorschicht nach Anspruch 1, wobei jedes einer Vielzahl von Garnen, die das erste leitfähige Gewebe der ersten Elektrodenschicht bilden, aus einer Faser gebildet ist.

6. Sensorschicht nach Anspruch 1, ferner umfassend: ein zweites Hilfselement (100),
wobei das zweite Hilfselement ein zweites leitfähiges Material (80a) umfasst, das leitfähig ist, auf einer anderen Oberfläche auf einer der Oberfläche der ersten Elektrodenschicht gegenüberliegenden Seite in einem Zustand angeordnet ist, in dem das erste leitfähige Gewebe und das zweite leitfähige Material elektrisch verbunden sind, und einen elektrischen Leitungsweg an einem Abschnitt bildet, an dem die erste Metallschicht unterbrochen ist.

7. Sensorschicht nach Anspruch 6, wobei in einer Laminierungsrichtung, in der das erste Hilfselement auf die erste Elektrodenschicht laminiert ist, das zweite Hilfselement an einer Position angeordnet ist, die sich mit mindestens einem Abschnitt des ersten Hilfselements überlappt.

8. Sensorschicht nach Anspruch 6, wobei in einer Laminierungsrichtung, in der das erste Hilfselement auf die erste Elektrodenschicht laminiert ist, das zweite Hilfselement an einer Position angeordnet ist, die sich nicht mit dem ersten Hilfselement überlappt.

9. Sensorschicht nach Anspruch 1, wobei das erste Hilfselement eine Vielzahl von ersten geteilten Hilfselementen (150) ist, die in Abständen angeordnet sind.

10. Sensorschicht nach Anspruch 6, wobei das zweite Hilfselement eine Vielzahl von zweiten geteilten Hilfselementen (160) ist, die diskret in Abständen angeordnet sind.

11. Sensorschicht nach Anspruch 1, wobei die erste Elektrodenschicht einen Halsabschnitt (25b, 25e), der schmaler als andere benachbarte Abschnitte ist, und einen verbreiterten Abschnitt (25c) umfasst, der benachbart zu dem Halsabschnitt angeordnet und breiter als der Halsabschnitt ist, und
das erste Hilfselement in einem Bereich angeordnet ist, der mindestens einen Abschnitt des Halsabschnitts in der ersten Elektrodenschicht umfasst.

12. Sensorschicht nach Anspruch 11, wobei das erste Hilfselement so angeordnet ist, dass es sich über den Halsabschnitt und den verbreiterten Abschnitt erstreckt.

13. Sensorschicht nach Anspruch 11, wobei die erste Elektrodenschicht einen sich in Längsrichtung erstreckenden Körperabschnitt (25a) umfasst, und
der Halsabschnitt in dem Körperabschnitt so gebildet ist, dass er in einer die Längsrichtung kreuzenden Querrichtung schmal ist.

14. Sensorschicht nach Anspruch 11, wobei die erste Elektrodenschicht umfasst:
einen Körperabschnitt, der so gebildet ist, dass er sich in Längsrichtung erstreckt; und
einen Verlängerungsabschnitt (25d), der sich von dem Körperabschnitt in einer die Längsrichtung kreuzenden Richtung erstreckt,
wobei ein Anschlussabschnitt (25f), der mit einer externen Schaltung verbunden ist, an einer Position nahe einer Spitze des Verlängerungsabschnitts gebildet ist, und
der Halsabschnitt in dem Verlängerungsabschnitt zwischen dem Körperabschnitt und dem Anschlussabschnitt gebildet ist.

15. Sensorschicht nach Anspruch 1, wobei das zweite leitfähige Gewebe aus demselben Material wie das erste leitfähige Gewebe gebildet ist.

16. Sensorschicht nach Anspruch 1, wobei ein zweites Garn (62), das das zweite leitfähige Gewebe bildet, ein verdrillter Draht ist, bei dem eine Vielzahl von zweiten Fasern (63) verdrillt sind, oder ein nicht verdrillter Garnbündeldraht, bei dem die zweiten Fasern ohne Verdrillung gebündelt sind.

17. Sensorschicht nach Anspruch 1, wobei ein erstes Garn (42), das das erste leitfähige Gewebe bildet, aus einer ersten Faser (43) gebildet ist,
ein zweites Garn, das das zweite leitfähige Gewebe bildet, aus einer zweiten Faser gebildet ist, und
ein Durchmesser der zweiten Faser kleiner als der Durchmesser der ersten Faser ist.

18. Sensorschicht nach Anspruch 1, wobei ein erstes Garn, das das erste leitfähige Gewebe der ersten Elektrodenschicht bildet, und ein zweites Garn, das das zweite leitfähige Gewebe des ersten Hilfselements bildet, in derselben Richtung ausgerichtet sind.

19. Sensorschicht nach Anspruch 1, wobei die Isolierschicht aus einem Elastomer gebildet ist und
mindestens ein Abschnitt der ersten Elektrodenschicht und mindestens ein Abschnitt des ersten Hilfselements in das Elastomer eingebettet sind.

20. Sensorschicht nach Anspruch 1, wobei das erste leitfähige Material des ersten Hilfselements ein leitfähiges Haftmittel (92) ist, das einen leitfähigen Füllstoff und ein härtbares Harz umfasst.

21. Sensorschicht nach Anspruch 1, wobei das erste leitfähige Material des ersten Hilfselements ein leitfähiges Haftmittel (50d) ist, das einen leitfähigen Füllstoff und ein Haftmittel umfasst.

22. Sensorschicht nach Anspruch 1, wobei das erste leitfähige Material des ersten Hilfselements eine leitfähige Paste (93) ist, die einen leitfähigen Füllstoff und ein Bindemittelharz umfasst.

23. Sensorschicht nach Anspruch 1, wobei das erste leitfähige Material des ersten Hilfselements dasselbe Metall umfasst wie das Metall, das die erste Metallschicht bildet, die auf dem ersten leitfähigen Gewebe der ersten Elektrodenschicht gebildet ist.

24. Sensorschicht nach Anspruch 1, wobei das erste leitfähige Material des ersten Hilfselements leitfähiger Kohlenstoff oder Graphit ist.

25. Sensorschicht nach Anspruch 1, wobei das erste leitfähige Material des ersten Hilfselements ein Laminat ist aus:
einer Leiterschicht (50b), die einen Leiterkörper umfasst; und
einer leitfähigen Bindeschicht, die einen leitfähigen Füllstoff und ein härtbares Harz umfasst, oder einer leitfähigen Haftmittelschicht (50d), die einen leitfähigen Füllstoff und ein Bindemittelharz umfasst.

26. Sensorschicht nach Anspruch 25, wobei die Leiterschicht durch ein drittes leitfähiges Gewebe (51) gebildet ist, das auf einer Oberfläche eine aus Metall hergestellte dritte Metallschicht (54) aufweist.

27. Sensorschicht nach Anspruch 26, wobei das Metall, das die dritte Metallschicht des dritten leitfähigen Gewebes bildet, dasselbe ist wie das Metall, das die erste Metallschicht des ersten leitfähigen Gewebes bildet.

28. Sensorschicht nach Anspruch 26, wobei ein drittes Garn (52), das das dritte leitfähige Gewebe bildet, ein verdrillter Draht ist, in dem eine Vielzahl von dritten Fasern (53) verdrillt sind, oder ein nicht verdrillter Garnbündeldraht, bei dem die dritten Fasern ohne Verdrillung gebündelt sind

29. Sensorschicht nach Anspruch 26, wobei ein erstes Garn, das das erste leitfähige Gewebe bildet, aus einer ersten Faser gebildet ist,
ein drittes Garn, das das dritte leitfähige Gewebe bildet, aus einer dritten Faser gebildet ist, und
ein Durchmesser der dritten Faser kleiner ist als ein Durchmesser der ersten Faser.

30. Sensorschicht nach Anspruch 26, wobei ein Garn, das das erste leitfähige Gewebe der ersten Elektrodenschicht bildet, und ein Garn, das das dritte leitfähige Gewebe des ersten Hilfselements bildet, in derselben Richtung ausgerichtet sind.

31. Sensorschicht nach Anspruch 1, wobei eine Dicke des ersten Hilfselements kleiner als eine Dicke der ersten Elektrodenschicht ist.

32. Sensorschicht nach Anspruch 1, wobei die erste Elektrodenschicht so gebildet ist, dass sie sich in Längsrichtung erstreckt, und
ein Elastizitätsmodul des ersten Hilfselements in Längsrichtung größer als ein Elastizitätsmodul der ersten Elektrodenschicht in Längsrichtung ist.

33. Sensorschicht nach Anspruch 1, wobei die erste Elektrodenschicht so gebildet ist, dass sie sich in Längsrichtung erstreckt, und
eine Biegefestigkeit des ersten Hilfselements, wenn das erste Hilfselement unter Verwendung einer Faltlinie in einer Richtung gebogen wird, die die Längsrichtung in einer Ebene des ersten Hilfselements kreuzt, größer ist als eine Biegefestigkeit der ersten Elektrodenschicht, wenn die erste Elektrodenschicht unter Verwendung einer Faltlinie in einer Richtung gebogen wird, die die Längsrichtung in einer Ebene der ersten Elektrodenschicht kreuzt.

34. Sensorschicht nach Anspruch 1, wobei die erste Elektrodenschicht so gebildet ist, dass sie sich in Längsrichtung erstreckt, und
ein elektrischer spezifischer Widerstand des ersten Hilfselements in Längsrichtung gleich oder kleiner als ein elektrischer spezifischer Widerstand der ersten Elektrodenschicht in Längsrichtung ist.

35. Sensorschicht nach Anspruch 1, ferner umfassend:
eine zweite Elektrodenschicht (26), die unter Verwendung eines vierten leitfähigen Gewebes (71) gebildet ist, das auf einer Oberfläche eine aus Metall hergestellte vierte Metallschicht (74) aufweist, und die auf einer anderen Oberfläche der Isolierschicht angeordnet ist; und
ein drittes Hilfselement (80), das ein zweites leitfähiges Material (80a) umfasst, das leitfähig ist, auf einer Oberfläche der zweiten Elektrodenschicht in einem Zustand angeordnet ist, in dem das vierte leitfähige Gewebe und das zweite leitfähige Material elektrisch verbunden sind, und an einem Abschnitt, an dem die vierte Metallschicht unterbrochen ist, einen elektrischen Leitungsweg bildet.

36. Sensorschicht nach Anspruch 35, wobei in einer Laminierungsrichtung, in der das dritte Hilfselement auf die zweite Elektrodenschicht laminiert ist, das dritte Hilfselement an einer Position angeordnet ist, die sich mit mindestens einem Abschnitt des ersten Hilfselements überlappt.

37. Sensorschicht nach Anspruch 35, wobei in einer Laminierungsrichtung, in der das dritte Hilfselement auf die zweite Elektrodenschicht laminiert ist, das dritte Hilfselement an einer Position angeordnet ist, die sich nicht mit dem ersten Hilfselement überlappt.

38. Sensorschicht nach Anspruch 35, wobei das dritte Hilfselement ein fünftes leitfähiges Gewebe (81) umfasst, das auf einer Oberfläche eine aus Metall hergestellte fünfte Metallschicht (84) aufweist.

39. Sensorschicht nach Anspruch 38, wobei das fünfte leitfähige Gewebe aus demselben Material wie das vierte leitfähige Gewebe gebildet ist.

## Revendications

1. Feuille de capteur (18), comprenant :
une feuille isolante (24) qui est isolante ;une première feuille d'électrode (25), formée à l'aide d'un premier tissu conducteur (41) qui comporte, sur une surface, une première couche de placage (44) en métal, et disposée sur une surface de la feuille isolante ; et
un premier élément auxiliaire (50), comprenant un premier matériau conducteur (50a) qui est conducteur, disposé sur une surface de la première feuille d'électrode dans un état dans lequel le premier tissu conducteur et le premier matériau conducteur sont connectés électriquement, et formant un chemin de conduction électrique au niveau d'une partie où la première couche de placage est rompue,
dans laquelle la feuille de capteur (18) est **caractérisée en ce que**
le premier élément auxiliaire est formé par un deuxième tissu conducteur (61) comportant, sur une surface, une deuxième couche de placage (64) en métal.

2. Feuille de capteur selon la revendication 1, dans laquelle la première feuille d'électrode comprend une partie d'ouverture (34) qui est un espace entre une pluralité de fils formant le premier tissu conducteur, et au moins une partie du premier élément auxiliaire est disposé à l'intérieur de la première partie d'ouverture.

3. Feuille de capteur selon la revendication 1, dans laquelle le premier élément auxiliaire est disposé sur une première surface (29a) située sur un côté opposé à la feuille isolante dans la première feuille d'électrode.

4. Feuille de capteur selon la revendication 1, dans laquelle le premier élément auxiliaire est disposé sur une deuxième surface (29b) située sur un côté de la feuille isolante dans la première feuille d'électrode.

5. Feuille de capteur selon la revendication 1, dans laquelle chacun d'une pluralité de fils formant le premier tissu conducteur de la première feuille d'électrode est constitué d'une seule fibre.

6. Feuille de capteur selon la revendication 1, comprenant en outre : un deuxième élément auxiliaire (100),dans laquelle le deuxième élément auxiliaire comprend un deuxième matériau conducteur (80a) qui est conducteur, est disposé sur une autre surface d'un côté opposé à la surface de la première feuille d'électrode, dans un état dans lequel le premier tissu conducteur et le deuxième matériau conducteur sont connectés électriquement, et forme un chemin de conduction électrique au niveau d'une partie où la première couche de placage est rompue.

7. Feuille de capteur selon la revendication 6, dans laquelle, dans une direction de stratification dans laquelle le premier élément auxiliaire est stratifié sur la première feuille d'électrode, le deuxième élément auxiliaire est disposé à une position chevauchant au moins une partie du premier élément auxiliaire.

8. Feuille de capteur selon la revendication 6, dans laquelle, dans une direction de stratification dans laquelle le premier élément auxiliaire est stratifié sur la première feuille d'électrode, le deuxième élément auxiliaire est disposé à une position ne chevauchant pas le premier élément auxiliaire.

9. Feuille de capteur selon la revendication 1, dans laquelle le premier élément auxiliaire est constitué d'une pluralité de premiers éléments auxiliaires divisés (150) disposés à intervalles réguliers.

10. Feuille de capteur selon la revendication 6, dans laquelle le deuxième élément auxiliaire est constitué d'une pluralité de deuxièmes éléments auxiliaires divisés (160) disposés de manière discontinue à intervalles réguliers.

11. Feuille de capteur selon la revendication 1, dans laquelle la première feuille d'électrodes comprend une partie rétrécie (25b, 25e) plus étroite que les autres parties adjacentes et une partie élargie (25c) disposée de manière adjacente à la partie rétrécie et plus large que celle-ci, et le premier élément auxiliaire est disposé dans une région comprenant au moins une partie de la partie rétrécie de la première feuille d'électrode.

12. Feuille de capteur selon la revendication 11, dans laquelle le premier élément auxiliaire est disposé de manière à enjamber la partie rétrécie et la partie élargie.

13. Feuille de capteur selon la revendication 11, dans laquelle la première feuille d'électrode comprend une partie de corps (25a) allongée dans une direction longitudinale, et la partie rétrécie est formée, dans la partie de corps, de manière à être étroite dans une direction transversale croisant la direction longitudinale.

14. Feuille de capteur selon la revendication 11, dans laquelle la première feuille d'électrode comprend :
une partie de corps, formée de manière à être allongée dans une direction longitudinale ; et
une partie d'extension (25d), s'étendant dans une direction croisant la direction longitudinale à partir de la partie de corps,
dans laquelle une partie de borne (25f) connectée à un circuit externe est formée à une position proche d'une extrémité de la partie d'extension, et
la partie rétrécie est formée, dans la partie d'extension, entre la partie de corps et la partie de borne.

15. Feuille de capteur selon la revendication 1, dans laquelle le deuxième tissu conducteur est formé d'un matériau identique à celui du premier tissu conducteur.

16. Feuille de capteur selon la revendication 1, dans laquelle un deuxième fil (62) formant le deuxième tissu conducteur est un fil torsadé dans lequel une pluralité de deuxièmes fibres (63) sont torsadées ou un fil en faisceau non torsadé dans lequel les deuxièmes fibres sont regroupées sans être torsadées.

17. Feuille de capteur selon la revendication 1, dans laquelle un premier fil (42) formant le premier tissu conducteur est constitué d'une première fibre (43),un deuxième fil formant le deuxième tissu conducteur est constitué d'une deuxième fibre, et
le diamètre de la deuxième fibre est inférieur au diamètre de la première fibre.

18. Feuille de capteur selon la revendication 1, dans laquelle un premier fil formant le premier tissu conducteur de la première feuille d'électrode et un deuxième fil formant le deuxième tissu conducteur du premier élément auxiliaire sont orientés dans la même direction.

19. Feuille de capteur selon la revendication 1, dans laquelle la feuille isolante est formée d'un élastomère, et
au moins une partie de la première feuille d'électrode et au moins une partie du premier élément auxiliaire sont noyées dans l'élastomère.

20. Feuille de capteur selon la revendication 1, dans laquelle le premier matériau conducteur du premier élément auxiliaire est un adhésif conducteur (92) comprenant une charge conductrice et une résine durcissable.

21. Feuille de capteur selon la revendication 1, dans laquelle le premier matériau conducteur du premier élément auxiliaire est un adhésif conducteur (50d) comprenant une charge conductrice et un adhésif.

22. Feuille de capteur selon la revendication 1, dans laquelle le premier matériau conducteur du premier élément auxiliaire est une pâte conductrice (93) comprenant une charge conductrice et une résine liante.

23. Feuille de capteur selon la revendication 1, dans laquelle le premier matériau conducteur du premier élément auxiliaire comprend un métal identique au métal formant la première couche de placage formée sur le premier tissu conducteur de la première feuille d'électrode.

24. Feuille de capteur selon la revendication 1, dans laquelle le premier matériau conducteur du premier élément auxiliaire est du carbone conducteur ou du graphite.

25. Feuille de capteur selon la revendication 1, dans laquelle le premier matériau conducteur du premier élément auxiliaire est un stratifié constitué :
d'une couche conductrice (50b), comprenant un corps conducteur ; et
d'une couche de liaison conductrice comprenant une charge conductrice et une résine durcissable ou d'une couche adhésive conductrice (50d) comprenant une charge conductrice et une résine liante.

26. Feuille de capteur selon la revendication 25, dans laquelle la couche conductrice est formée par un troisième tissu conducteur (51) comportant, sur une surface, une troisième couche de placage (54) en métal.

27. Feuille de capteur selon la revendication 26, dans laquelle le métal formant la troisième couche de placage du troisième tissu conducteur est le même que le métal formant la première couche de placage du premier tissu conducteur.

28. Feuille de capteur selon la revendication 26, dans laquelle un troisième fil (52) formant le troisième tissu conducteur est un fil torsadé dans lequel une pluralité de troisièmes fibres (53) sont torsadées ou un fil en faisceau non torsadé dans lequel les troisièmes fibres sont regroupées sans être torsadées.

29. Feuille de capteur selon la revendication 26, dans laquelle un premier fil formant le premier tissu conducteur est constitué d'une première fibre,
un troisième fil formant le troisième tissu conducteur est constitué d'une troisième fibre, et le diamètre de la troisième fibre est inférieur au diamètre de la première fibre.

30. Feuille de capteur selon la revendication 26, dans laquelle un fil formant le premier tissu conducteur de la première feuille d'électrode et un fil formant le troisième tissu conducteur du premier élément auxiliaire sont orientés dans la même direction.

31. Feuille de capteur selon la revendication 1, dans laquelle l'épaisseur du premier élément auxiliaire est inférieur à l'épaisseur de la première feuille d'électrode.

32. Feuille de capteur selon la revendication 1, dans laquelle la première feuille d'électrode est formée de manière à s'étirer dans une direction longitudinale, et
un module d'élasticité du premier élément auxiliaire dans la direction longitudinale est supérieur à un module d'élasticité de la première feuille d'électrode dans la direction longitudinale.

33. Feuille de capteur selon la revendication 1, dans laquelle la première feuille d'électrode est formée de manière à s'étirer dans une direction longitudinale, et
la résistance à la flexion du premier élément auxiliaire, lorsque celui-ci est plié en utilisant une ligne de pliage dans une direction croisant la direction longitudinale dans un plan du premier élément auxiliaire, est supérieure à la résistance à la flexion de la première feuille d'électrode, lorsque celle-ci est pliée en utilisant une ligne de pliage dans une direction croisant la direction longitudinale dans un plan de la première feuille d'électrode.

34. Feuille de capteur selon la revendication 1, dans laquelle la première feuille d'électrode est formée de manière à s'étendre dans une direction longitudinale, et
la résistivité électrique du premier élément auxiliaire dans la direction longitudinale est égal ou inférieur à la résistivité électrique de la première feuille d'électrode dans la direction longitudinale.

35. Feuille de capteur selon la revendication 1, comprenant en outre :
une deuxième feuille d'électrode (26), formée à l'aide d'un quatrième tissu conducteur (71) qui comporte, sur une surface, une quatrième couche de placage (74) formée de métal, et
disposée sur une autre surface de la feuille isolante ; et
un troisième élément auxiliaire (80), comprenant un deuxième matériau conducteur (80a) qui est conducteur, est disposé, sur une surface de la deuxième feuille d'électrode, dans un état dans lequel le quatrième tissu conducteur et le deuxième matériau conducteur sont connectés électriquement, et forme un chemin de conduction électrique au niveau d'une partie où la quatrième couche de placage est rompue.

36. Feuille de capteur selon la revendication 35, dans laquelle, dans une direction de stratification dans laquelle le troisième élément auxiliaire est stratifié sur la deuxième feuille d'électrode, le troisième élément auxiliaire est disposé à une position chevauchant au moins une partie du premier élément auxiliaire.

37. Feuille de capteur selon la revendication 35, dans laquelle, dans une direction de stratification dans laquelle le troisième élément auxiliaire est stratifié sur la deuxième feuille d'électrode, le troisième élément auxiliaire est disposé à une position ne chevauchant pas le premier élément auxiliaire.

38. Feuille de capteur selon la revendication 35, dans laquelle le troisième élément auxiliaire comprend un cinquième tissu conducteur (81) qui comporte, sur une surface, une cinquième couche de placage (84) en métal.

39. Feuille de capteur selon la revendication 38, dans laquelle le cinquième tissu conducteur est formé d'un matériau identique à celui du quatrième tissu conducteur.
